# EUROPEAN PATENT APPLICATION

(11) **EP 1 391 944 A2**
(43) Date of publication of application: **25.02.2004**
(21) Application number: 03077496.2
(22) Date of filing: 11.08.2003
(51) Int. Cl.: H01L 51/20

(54) **Solid state lighting using compressed fluid coatings**

(30) Priority: 21.08.2002 US 224783; 20.11.2002 US 300099
(71) Applicant: EASTMAN KODAK COMPANY, Rochester, New York 14650 (US)
(72) Inventor: Jagannathan, Ramesh, c/o Eastman Kodak Company, Rochester, New York 14650-2201 (US); Sunderrajan, Suresh, c/o Eastman Kodak Company, Rochester, New York 14650-2201 (US); Jagannathan, Seshadri, c/o Eastman Kodak Company, Rochester, New York 14650-2201 (US); Irvin, Glen C., c/o Eastman Kodak Company, Rochester, New York 14650-2201 (US); Rueping, John E., c/o Eastman Kodak Company, Rochester, New York 14650-2201 (US); Sadasivan, Sridhar, c/o Eastman Kodak Company, Rochester, New York 14650-2201 (US); Merz, Gary E., c/o Eastman Kodak Company, Rochester, New York 14650-2201 (US); Nelson, David J., c/o Eastman Kodak Company, Rochester, New York 14650-2201 (US)
(74) Representative: Haile, Helen Cynthia

(57) **Abstract**

A method is taught for forming a layer of polymeric electroluminescent material having a controlled thickness and surface uniformity. A polymeric electroluminescent material is delivered to a vessel. A fluid to the vessel is also delivered to the vessel. The fluid and the polymeric electroluminescent material in the vessel are compressed and heated to form a thermodynamically stable or metastable mixture. The thermodynamically stable or metastable mixture is sprayed at a surface, the fluid vaporizing during spraying with the the polymeric electroluminescent material being deposited as a light emitting layer on the surface.

## Description

The present invention relates generally to the field of electroluminescent lighting, and more particularly, to methods employing compressed fluid solutions and/or dispersions for depositing layers of organic polymeric electroluminescent material on substrates for use in solid state lighting applications.

Electroluminescent (EL) materials are those that convert electrical energy into visible light. As such, these materials find application in solid state lighting because of advantages such as higher efficiency, lower power consumption, and longer lifetimes. EL materials may be inorganic or organic. Inorganic EL materials are semiconductor materials that convert electricity to light. Electrons are caused to move across a p-n junction from the n-region to the p-region and recombine with positive charges (holes). Recombination of electrons and holes results in the emission of energy in the visible wavelengths. The wavelength of emitted light is a function of the semiconductor band-gap with wider band-gaps resulting in higher frequency (or smaller wavelength) emission. Common inorganic EL materials include Aluminum Galium Arsenide (AlGaAs-Red), Aluminum Indium Galium Phosphide (AlInGaP-Yellow), Indium Galium Nitride (InGaN-Blue and Green), etc. Inorganic EL devices (or Light Emitting Diodes LEDs) are made through epitaxial crystal growth processes or through chemical vapor deposition processes. The deposited semiconductor chips are then encapsulated using plastic (epoxy) materials. Light output is a function of the semiconductor materials, manufacturing process, packaging configuration, drive current, and operating environment. Relatively long lifetimes, small size, and ruggedness make them useful in lighting applications. However, these devices are relatively rigid making them inapplicable for flexible lighting applications. In addition, they are typically point light sources making them preferred as directional light sources but less preferred for diffuse lighting applications such as general area illumination. For the latter applications, organic light emitting materials are preferred.

Organic light emitting devices (OLED) are classified into small molecule (SMOLED) and polymeric light emitting devices (PLED). Such materials are suitable for lighting applications because of their high processability, durability, low power consumption, wide color gamut, and wide emission angles.

In simplest form, an OLED is comprised of an anode for hole injection, a cathode for electron injection, and an organic or polymeric medium sandwiched between these electrodes to support charge recombination that yields emission of light. Representative of earlier organic EL devices are U.S. Patent No. 3,172,862 to Gurnee et al, U.S. Patent No. 3,173,050 to Gumee, Dresner, "Double Injection Electroluminescence in Anthracene", RCA Review, Vol. 30, pp. 322-334, 1969; U.S. Patent. No. 3,710,167 to Dresner and U.S. Patents 4,769,292 and 4,885,211 both to Tang et al. In a basic two-layer EL device structure, described first in US Patent No.4,356,429 to Tang, one organic layer of the EL element adjacent to the anode is specifically chosen to transport holes, therefore, it is referred to as the hole transport layer, and the other organic layer is specifically chosen to transport electrons, referred to as the electron transport layer. The interface between the two layers provides an efficient site for the recombination of the injected hole/electron pair and the resultant electroluminescence. There have also been proposed three-layer organic EL devices that contain an organic light-emitting layer (LEL) between the hole-transporting layer and electron-transporting layer, such as that disclosed by Tang et al in *J. Applied Physics,* Vol. 65, Pages 3610-3616, 1989. The light-emitting layer commonly consists of a host material doped with a guest material. Still further, there has been proposed in US Patent No. 4,769,292 to Tang et al, a four-layer EL element comprising a hole-injecting layer (HIL), a hole-transporting layer (HTL), a light-emitting layer (LEL) and an electron transport/injection layer (ETL).

The organic materials mentioned above are suitably deposited through sublimation, but can be deposited from a solvent with an optional binder to improve film formation. If the material is a polymer, solvent deposition is usually preferred, as described in US Patent No 5,247,190 and US Patent No. 5,401,827. The material to be deposited by sublimation can be vaporized from a sublimator "boat" often comprised of a tantalum material, e.g., as described in US Patent No. 6,237,529 to Spahn, or can be first coated onto a donor sheet and then sublimed in closer proximity to the substrate. Layers with a mixture of materials can utilize separate sublimator boats or the materials can be pre-mixed and coated from a single boat or donor sheet. Patterned deposition can be achieved using shadow masks, integral shadow masks (US Patent No. 5,294,870 to Tang, et al), spatially-defined thermal dye transfer from a donor sheet (US Patent Nos. 5,851,709 to Adinolfi and 6,066,357 to Tang, et al) and inkjet methods (US 6,066,357 to Tang, et al). In each of the above deposition techniques, however, there are drawbacks. Sublimation processes are restricted to materials that may be sublimed, excluding, for example, most polymeric materials which decompose instead of subliming. Typical solvent methods, such as spin coating, utilize solvents that are potentially harmful to health and the environment in addition to requiring subsequent solvent drying steps to eliminate residual solvents. This makes such processes difficult, slow, and expensive. In addition, uniform deposition onto non-planar surfaces, such as may be required by solid state lighting applications, is difficult, if not impossible, with the above deposition techniques.

Japanese Patent 09288970 A discloses a forming method for a bulb inner wall coating by constituting a supercritical fluid coating with a composition of a water suspension containing fluorescent fine particles and carbon dioxide as a supercritical fluid. However, there are many problems with this process. The use of a water suspension necessitates drying to eliminate the water present. Further, any water suspensions of OLED materials will result in extremely poor lifetimes, if there is any electroluminescence exhibited at all, because of moisture-related device contamination. The fluorescent powder is dispersed in water making it susceptible to agglomeration, settling and other mixture-related issues. Further, the spray coating processes disclosed in the patent result in highly non-uniform coatings that would make solid state devices that are substantially inferior in performance.

Huck et al., in WO 02/45868 A2, discloses a method of creating a pattern on a surface of a wafer using compressed carbon dioxide. The method includes dissolving or suspending a material in a solvent phase containing compressed carbon dioxide, and depositing the solution or suspension onto the surface of the wafer, the evaporation of the solvent phase leaving a patterned deposit of the material. The wafer is pre-patterned using lithography to provide the wafer with hydrophilic and hydrophobic areas. After deposition of the solution (or suspension) onto the wafer surface followed by the evaporation of the solvent phase, the material (a polymer) adheres to one of the hydrophobic and hydrophilic areas. The solution (or suspension) is deposited on the wafer surface either in the form of liquid drops or a feathered spray.

It is therefore an object of the present invention to provide a method of depositing a functional layer of material on a substrate using compressed fluids such as compressed gases, liquids or supercritical fluids.

It is a further object of the present invention to provide a method of depositing a layer of organic polymeric electroluminescent material on a substrate using compressed fluids based solutions and/or dispersions of organic polymeric electroluminescent materials or other functional layer materials that may be useful in polymeric electroluminescent lighting devices.

It is a feature of the present invention to provide a method of depositing organic thin films on a substrate using compressed fluids such as compressed gases, liquids or supercritical fluids useful in forming polymeric electroluminescent lighting devices for use in solid state lighting applications.

Yet another feature of the present invention is to create organic thin film coatings/deposits that are solvent-free.

A further feature of the present invention is to provide a method that can be used to deposit organic thin film coatings/deposits on flexible substrates.

It is another feature of the present invention to provide a method that can be used to deposit organic thin film coatings on substrates that are not planar. Briefly stated, the foregoing and numerous other features, objects and advantages of the present invention will become readily apparent upon a review of the detailed description, claims and drawings set forth herein. These features, objects and advantages are accomplished by providing an apparatus and method of coating/depositing a functional material for solid state lighting applications. The apparatus includes a pressurized source of the compressed fluid in a thermodynamically stable or metastable mixture with a functional material. A discharge device having an inlet and an outlet is connected to the pressurized source at the inlet. The discharge device is shaped to produce a spray of functional material projected in a generally circular or elliptical pattern, although other patterns such as squares and rectangles or hexagons may also be used if desired, where the fluid is in a gaseous state at a location before or beyond the outlet of the discharge device. The shape of the spray pattern as delivered to the substrate can be modified by placing a mask between the spray nozzle and the substrate. The compressed fluid in the pressurized source can be one of a dense gas, compressed liquid, or a supercritical fluid of density greater than 0.1 g/cc. The thermodynamically stable or metastable mixture includes one of the functional materials being dispersed in the fluid and/or the functional material being dissolved in the fluid.

The method of the present invention allows for the formation of a layer of polymeric electroluminescent material having a controlled thickness and surface uniformity. One key property of the various layers that is needed for an organic polymeric electroluminscent device is surface uniformity. Typically, a surface roughness of the order of 10 Angstroms or less is desirable for a high quality device, although surface roughnesses of up to three orders of magnitude higher than that may be adequate for some purposes and devices.

In the detailed description of the preferred embodiments of the invention presented below, reference is made to the accompanying drawings, in which:
FIG. 1A is a schematic view of a preferred embodiment made in accordance with the present invention;
FIGS. 1B-1G are schematic views of alternative embodiments made in accordance with the present invention;
FIG. 2A is a block diagram of a discharge device made in accordance with the present invention;
FIGS 2B-2J are cross sectional views of a nozzle portion of the device shown in FIG 2A;
FIGS 3A-3D are diagrams schematically representing the operation of the present invention; and
FIGS. 4A-4K are cross sectional views of a portion of the invention shown in FIG. 1A.
FIG 5 is a cross sectional view of an OLED device.
FIG 6 depicts a schematic cross-sectional view of a stacked OLED lighting structure having stacked organic EL units and having a doped organic connector in between each of the organic EL units.
FIG 7 depicts a schematic cross-sectional view of another stacked OLED lighting structure illustrating some layer structures in the organic EL unit.
FIG 8 depicts a schematic cross-sectional view of yet another stacked OLED lighting structure illustrating some other layer structures in the organic EL unit.
FIG 9 depicts a schematic cross-sectional view of a stacked OLED illustrating a doped organic connector that includes an n-type doped organic layer and a p-type doped organic layer.
FIG 10 shows a phase diagram of a typical material such as carbon dioxide.

The present description will be directed in particular to elements forming part of, or cooperating more directly with, apparatus in accordance with the present invention. It is to be understood that elements not specifically shown or described may take various forms well known to those skilled in the art. Additionally, materials identified as suitable for various facets of the invention, for example, functional materials, solvents, equipment, etc. are to be treated as exemplary, and are not intended to limit the scope of the invention in any manner.

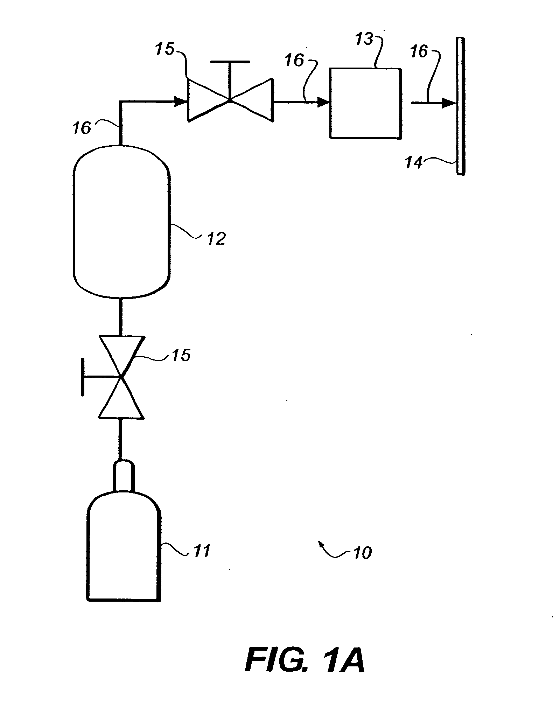

Referring to FIG. 1A, delivery system 10 has components, 11, 12, and 13 that take chosen solvent and/or dispersant materials to a compressed gas, liquid and/or supercritical fluid state, make a solution and/or dispersion of an appropriate functional material or combination of functional materials in the chosen compressed fluid with a density greater than 0.1 g/cc, and deliver the functional materials onto a receiver 14 in a controlled manner. Functional materials can be any material that needs to be delivered to a receiver, for example electroluminescent materials, hole transport materials, electron transport materials, etc., to create a coating on the receiver by deposition and/or coating of a functional material. A receiver is any substrate that is suitable for a lighting application. Exemplary substrates include, for example, glass, silicon, polymeric materials, metals, alloys and ceramics.

In this context, the chosen materials taken to a compressed fluid state are gases at ambient pressure and temperature. The compressed fluid has a density that is greater than or equal to 0.1 grams per cubic centimeter. Such fluids are able to dissolve and/or disperse, and hold in solution and/or dispersion, functional solute materials of interest. Ambient conditions are preferably defined as temperature in the range from-100 to +100 °C, and pressure in the range from 1x10⁻⁸ - 100 atm for this application. More preferably, ambient conditions are defined as temperature in the range from -20 to +50 °C, and pressure in the range from 1x10⁻⁸ - 10 atm

In FIG. 1A a schematic illustration of the delivery system 10 is shown. The delivery system 10 has a compressed fluid source 11, a formulation reservoir 12, and a discharge device 13 connected in fluid communication along a delivery path 16. The delivery system 10 can also include a valve or valves 15 positioned along the delivery path 16 in order to control flow of the compressed fluid.

A compressed fluid carrier, contained in the compressed fluid source 11, is any material that dissolves/solubilizes/disperses a functional material. The compressed fluid source 11 delivers the compressed fluid carrier at predetermined conditions of pressure, temperature, and flow rate as a compressed gas or a compressed liquid or supercritical fluid, all of density greater than 0.1 g/cc. Materials that are above their critical point, defined by a critical temperature and a critical pressure, are known as supercritical fluids. The critical temperature and critical pressure typically define a thermodynamic state in which a fluid or a material becomes supercritical and exhibits gas like and liquid like properties. Materials that are at sufficient temperatures and pressures below their critical point are known as compressed liquids. Materials in their compressed fluid state with a density greater than 0.1 g/cc that exist as gases at ambient conditions find application here because of their unique ability to solubilize and/or disperse functional materials of interest in the compressed fluid state.

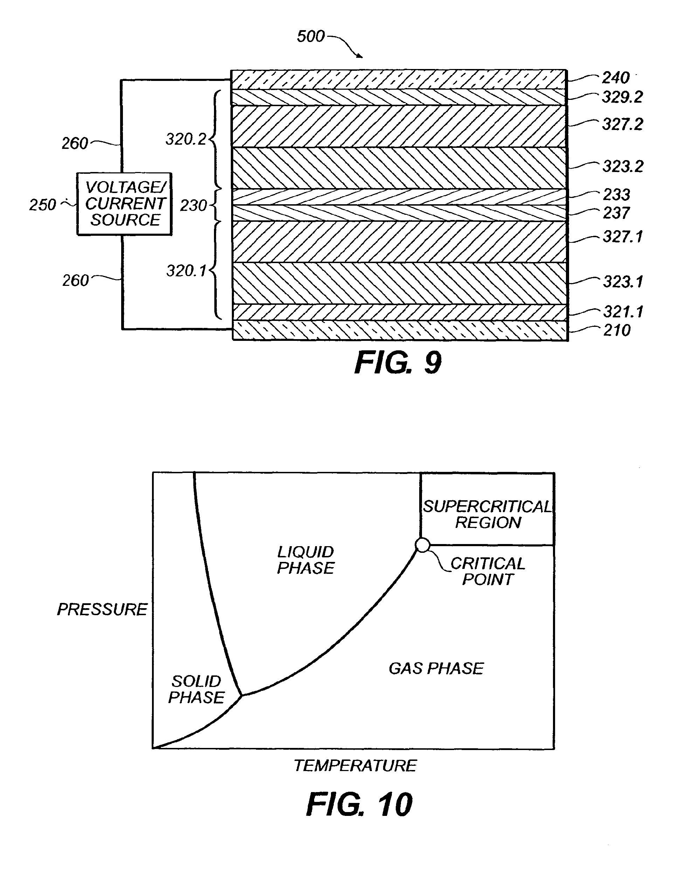

Fig 10 shows a phase diagram of a typical material such as carbon dioxide. As pressure and temperature are increased, such a material, for example, carbon dioxide, which is a gas at atmospheric pressure and room temperature, changes into a compressed fluid (either liquid or compressed gas) until a certain critical temperature and critical pressure defined by the critical point in the diagram. At temperatures and pressures above this critical point, the material is said to be in supercritical state, for example supercritical carbon dioxide. A key property of materials undergoing such changes in pressure and temperature conditions is their density, which typically increases with increasing pressure and temperature. As mentioned earlier, materials with a density greater than 0.1 gram/cubic centimeter, and the necessary pressure and temperature conditions thereof, that exist as gases as ambient conditions, fmd application here because of their unique ability to solubilize and/or disperse functional materials of interest.

Fluid carriers include, but are not limited to, carbon dioxide, nitrous oxide, ammonia, xenon, ethane, ethylene, propane, propylene, butane, isobutane, chlorotrifluoromethane, monofluoromethane, sulphur hexafluoride and mixtures thereof. Due to its characteristics, e.g. low cost, wide availability, etc., carbon dioxide is generally preferred in many applications.

The formulation reservoir 12 is utilized to dissolve and/or disperse functional materials in compressed gases, liquids or supercritical fluids with a density > 0.1 g/cc with or without dispersants and/or surfactants, at desired formulation conditions of temperature, pressure, volume, and concentration. The combination of functional material and compressed fluid is typically referred to as a mixture, formulation, etc.

The formulation reservoir 12 can be made out of any suitable materials that can safely operate at the formulation conditions. An operating range from 0.001 atmosphere (1.013 x 10² Pa) to 1000 atmospheres (1.013 x 10⁸ Pa) in pressure and from ―25°C to 1000°C is generally preferred. A more preferred range is from 50 to 400 atmospheres in pressure and from -20 to 100°C. Typically, the preferred materials include various grades of high-pressure stainless steel. However, it is possible to use other materials if the specific deposition application dictates less extreme conditions of temperature and/or pressure.

The formulation reservoir 12 should be precisely controlled with respect to the operating conditions (pressure, temperature, and volume). The solubility/dispersibility of functional materials depends upon the conditions within the formulation reservoir 12. As such, small changes in the operating conditions within the formulation reservoir 12 can have undesired effects on functional material solubility/dispensability.

Additionally, any suitable surfactant and/or dispersant material that is capable of solubilizing/dispersing the functional materials in the compressed fluid for a specific application can be incorporated into the mixture of functional material and compressed fluid. Such materials include, but are not limited to, fluorinated polymers such as perfluoropolyether, siloxane compounds, polyethercarbonate, etc.

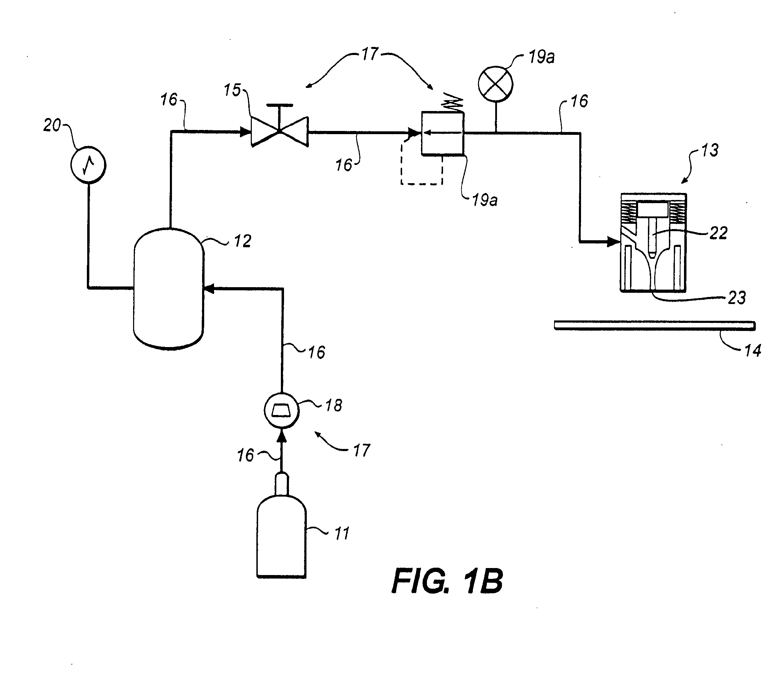

Referring to FIGS. 1B-1D, alternative embodiments of the invention shown in FIG. 1A are described. In each of these embodiments, individual components are in fluid communication, as is appropriate, along the delivery path 16.

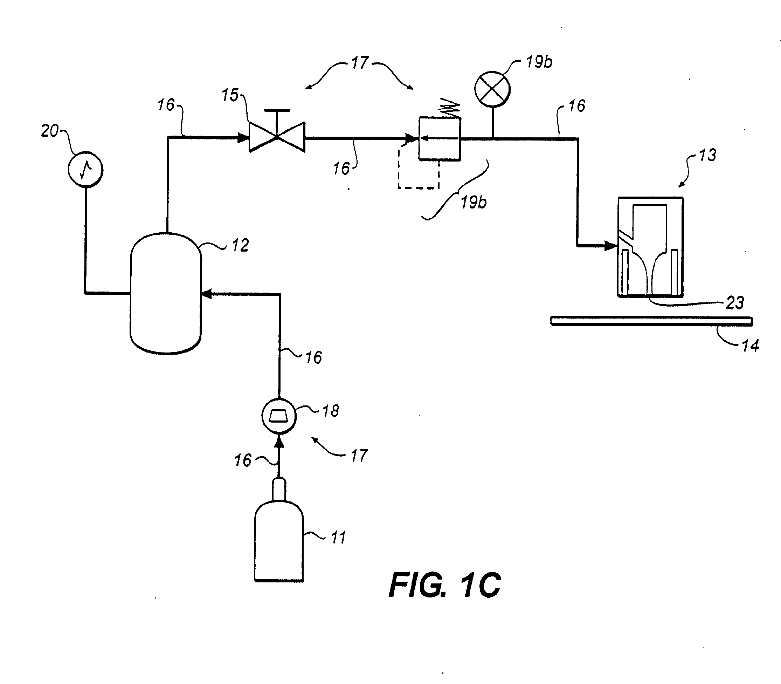

Referring to FIGS. 1B and 1C, a pressure control mechanism 17 is positioned along the delivery path 16. The pressure control mechanism 17 is used to create and maintain a desired pressure required for a particular application. The pressure control mechanism 17 can include a pump 18, a valve(s) 15, and a pressure regulator 19a, as shown in FIG. 1B. Alternatively, the pressure control mechanism 17 can include a pump 18, a valve(s) 15, and a multi-stage pressure regulator 19b, as shown in FIG. 1C. Additionally, the pressure control mechanism can include alternative combinations of pressure controlling devices, etc. For example, the pressure control mechanism 17 can include additional valve(s) 15, actuators to regulate fluid/formulation flow, variable volume devices to change system operating pressure, etc., appropriately positioned along the delivery path 16. Typically, the pump 18 is positioned along the delivery path 16 between the fluid source 11 and the formulation reservoir 12. The pump 18 can be a high-pressure pump that increases and maintains system operating pressure, etc. The pressure control mechanism 17 can also include any number of monitoring devices, gauges, etc., for monitoring the pressure of the delivery system 10.

A temperature control mechanism 20 is positioned along delivery path 16 in order to create and maintain a desired temperature for a particular application. The temperature control mechanism 20 is preferably positioned at the formulation reservoir 12. The temperature control mechanism 20 can include a heater, a heater including electrical wires, a water jacket, a refrigeration coil, a combination of temperature controlling devices, etc. The temperature control mechanism can also include any number of monitoring devices, gauges, etc., for monitoring the temperature of the delivery system 10.

The discharge device 13 includes a nozzle 23 positioned to provide directed delivery of the formulation towards the receiver 14. The discharge device 13 can also include a shutter 22 to regulate the flow of the compressed fluid and functional material mixture or formulation. The shutter 22 regulates flow of the formulation in a predetermined manner (i.e. on/off or partial opening operation at desired frequency, etc.). The shutter 22 can be manually, mechanically, pneumatically, electrically or electronically actuated. Alternatively, the discharge device 13 does not have to include the shutter 22 (shown in FIG. 1C). As the mixture is under higher pressure, as compared to ambient conditions, in the delivery system 10, the mixture will naturally move toward the region of lower pressure, the area of ambient conditions. In this sense, the delivery system is said to be self-energized.

The receiver 14 can be positioned on a media conveyance mechanism (not shown) that is used to control the movement of the receiver during the operation of the delivery system 10. The media conveyance mechanism can be a drum, an x, y, z translator, any other known media conveyance mechanism, etc. The media conveyance mechanism and receiver 14 may be enclosed in or be part of an enclosure that provides control over the ambient coating/deposition conditions. For example, it may be placed in a vacuum chamber or a high-pressure chamber containing nitrogen or some other inert gas.

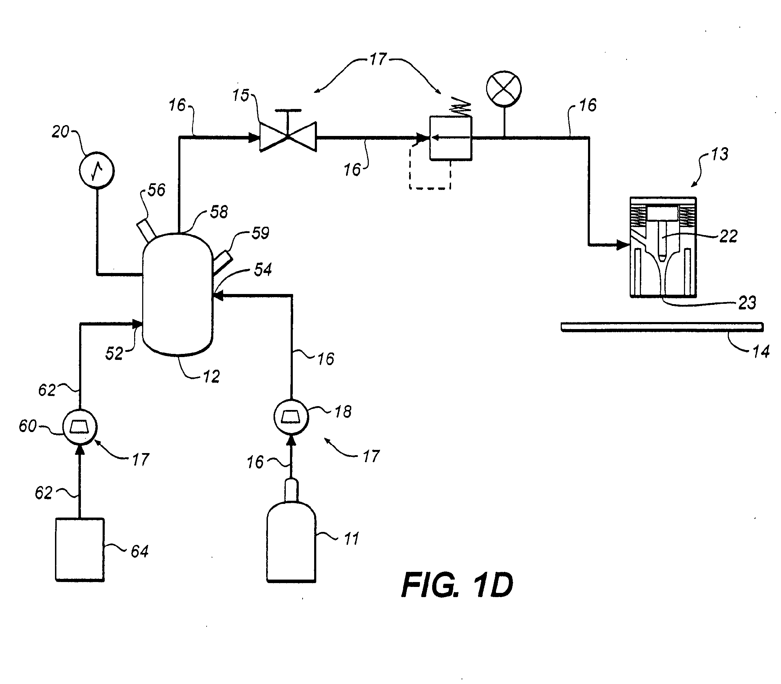

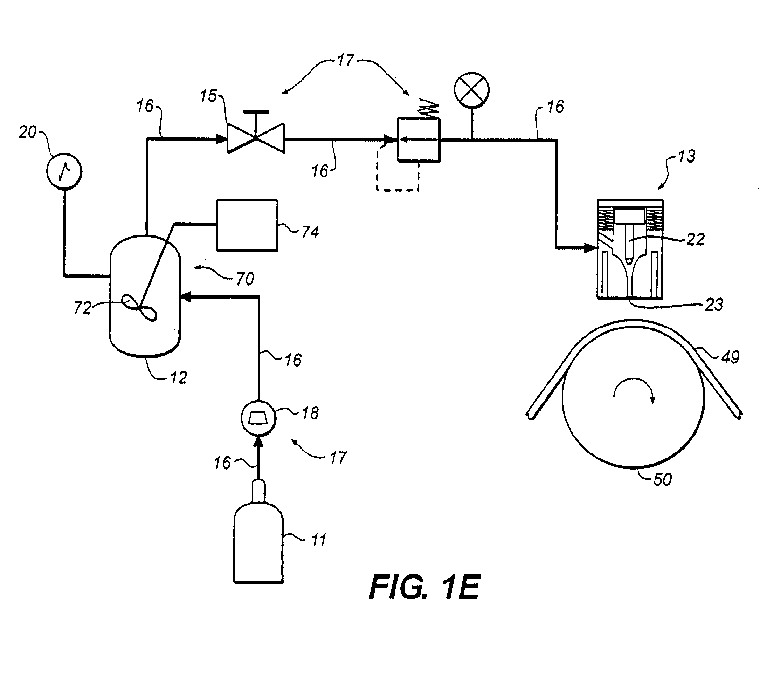

Referring to FIG 1D, the formulation reservoir 12 can be a pressurized vessel having appropriate inlet ports 52, 54, 56 and outlet ports 58. Inlet ports 52, 54, 56 can be used as an inlet 52 for functional material and an inlet 54 for compressed fluid. Alternatively, inlet port 56 can be used to manually add functional material to the formulation reservoir 12. Outlet port 58 can be used as an outlet for the mixture of functional material and compressed fluid. Note that Figure 1E depicts a nozzle 13 positioned over a moving flexible substrate 49 supported on a backing roller which is at least a portion of one example of a media conveyance mechanism 50.

When automated delivery of the functional material is desired, a pump 60 is positioned along a functional material delivery path 62 between a source of functional material 64 and the formulation reservoir 12. The pump 60 pumps a desired amount of functional material through inlet port 52 into the formulation reservoir 12. The formulation reservoir 12 can also include additional inlet/outlet ports 59 for inserting or removing small quantities of functional material or functional material and compressed fluid mixtures.

Referring to FIG. 1E, the formulation reservoir 12 can include a mixing device 70 used to create the mixture of functional material and compressed fluid. Although typical, a mixing device 70 is not always necessary to make the mixture of the functional material and compressed fluid depending on the type of functional material and the type of compressed fluid. The mixing device 70 can include a mixing element 72 connected to a power/control source 74 to ensure that the functional material disperses into or forms a solution with the compressed fluid. The mixing element 72 can be an acoustic, a mechanical, and/or an electromagnetic element.

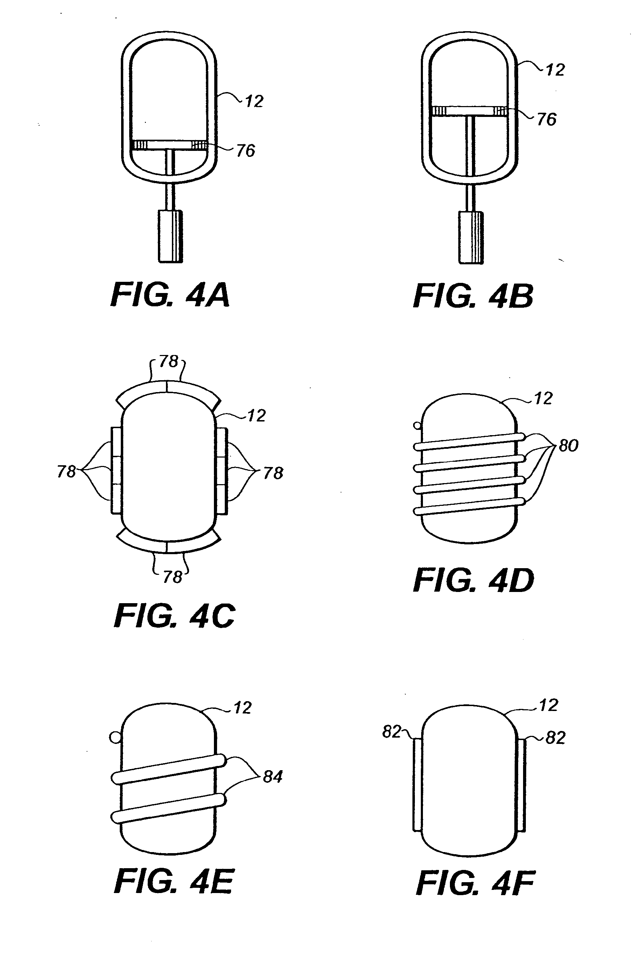

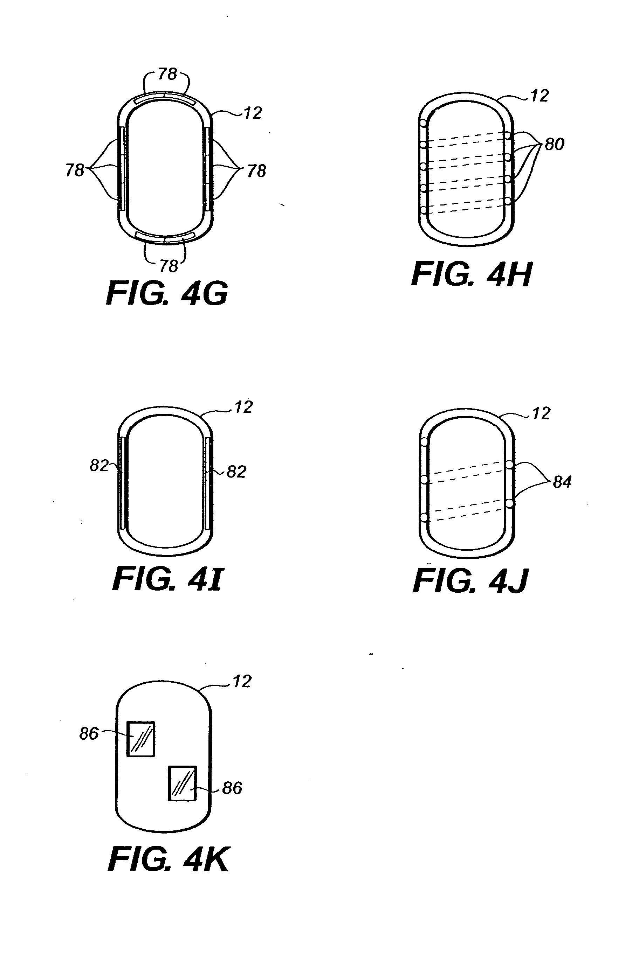

Referring to FIGS. 1D, 1E, and FIGS 4A-4J, the formulation reservoir 12 can also include suitable temperature control mechanisms 20 and pressure control mechanisms 17 (see Fig. 1D and 1E) with adequate gauging instruments to detect and monitor the temperature and pressure conditions within the reservoir, as described above. For example, the formulation reservoir 12 can include a moveable piston device 76, etc., (see Fig. 4D and 4H) to control and maintain pressure. The formulation reservoir 12 can also be equipped to provide accurate control over temperature within the reservoir. For example, the formulation reservoir 12 can include electrical heating/cooling zones 78 (see Fig. 4C and 4G), using electrical wires 80 (see Fig. 4D and 4H), electrical tapes, water jackets 82 (see Fig. 4F and 4I), other heating/cooling fluid jackets, refrigeration coils 84 (see Fig. 4E and 4J), etc., to control and maintain temperature. The temperature control mechanisms 20 can be positioned within the formulation reservoir 12 or positioned outside the formulation reservoir. Additionally, the temperature control mechanisms 20 can be positioned over a portion of the formulation reservoir 12, throughout the formulation reservoir 12, or over the entire area of the formulation reservoir 12.

Referring to FIG. 4K, the formulation reservoir 12 can also include any number of suitable high-pressure windows 86 for manual viewing or digital viewing using an appropriate fiber optics or camera set-up. The windows 86 are typically made of sapphire or quartz or other suitable materials that permit the passage of the appropriate frequencies of radiation for viewing/detection/analysis of reservoir contents (using visible, infrared, X-ray etc. viewing/detection/analysis techniques), etc.

The formulation reservoir 12 is made of appropriate materials of construction in order to withstand high pressures of the order of 10,000 psi or greater. Typically, stainless steel is the preferred material of construction although other high-pressure metals, metal alloys, and/or metal composites can be used.

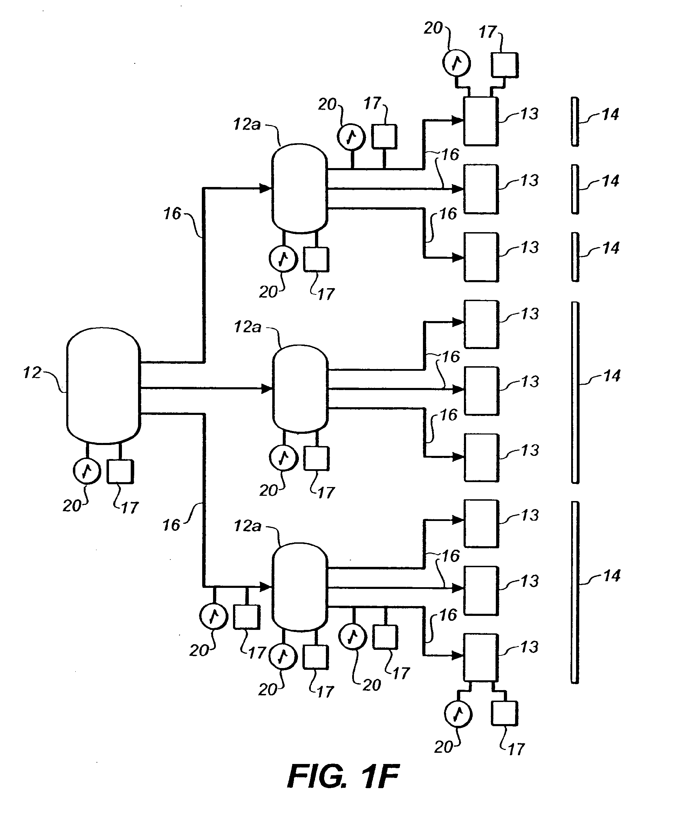

Referring to FIG. 1F, in an alternative arrangement, the thermodynamically stable/metastable mixture of functional material and compressed fluid can be prepared in one formulation reservoir 12 and then transported to one or more additional formulation reservoirs which are high pressure vessels 12a. For example, a single large formulation reservoir 12 can be suitably connected to one or more subsidiary high pressure vessels 12a that maintain the functional material and compressed fluid mixture at controlled temperature and pressure conditions with each subsidiary high pressure vessel 12a feeding one or more discharge devices 13. Either or both reservoirs 12 and 12a can be equipped with the temperature control mechanism 20 and/or pressure control mechanisms 17. The discharge devices 13 can direct the mixture towards a single receiver 14 or a plurality of receivers 14.

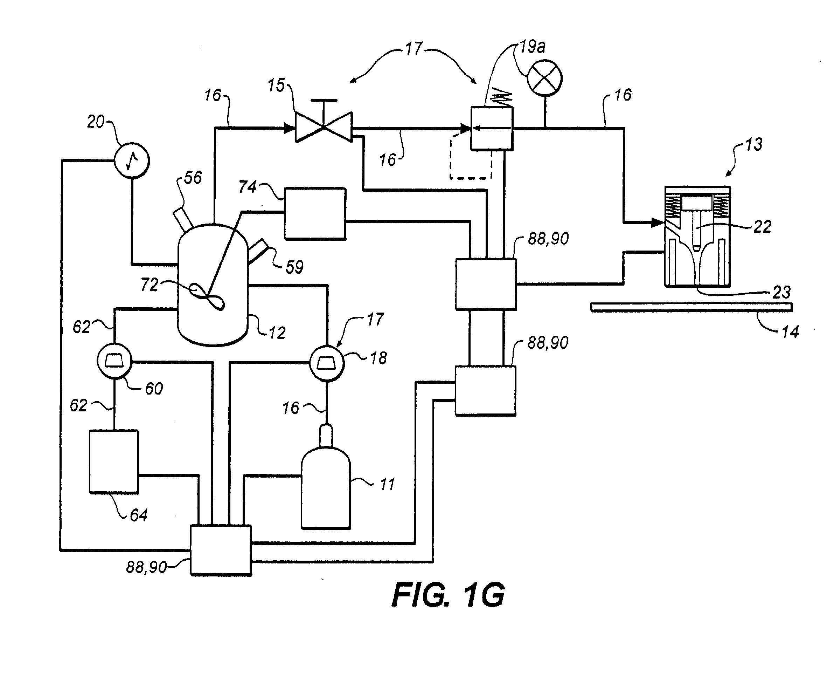

Referring to FIG. 1G, the delivery system 10 can include ports for the injection of suitable functional material, view cells, and suitable analytical equipment such as Fourier Transform Infrared Spectroscopy, Light Scattering, Ultraviolet or Visible Spectroscopy, etc. to permit monitoring of the delivery system 10 and the components of the delivery system. Additionally, the delivery system 10 can include any number of control devices 88, microprocessors 90, etc., used to control the delivery system 10.

Although Figures 1A through 1G depict nozzle(s) 13 delivering a spray to a substrate in open conditions, those skilled in the art will recognize that such coating application will typically be performed in an enclosure (not shown). The enclosure allows for control of the ambient conditions therein. The ambient conditions for the enclosure include the range of temperature, pressure, and humidity. Such conditions may be maintained by an inert gas such as, for example, carbon dioxide, nitrogen, argon, circulated to the enclosure. The range of preferred humidity conditions include 0-25%, more preferred being 0-5%, even more preferred being 0-1%.

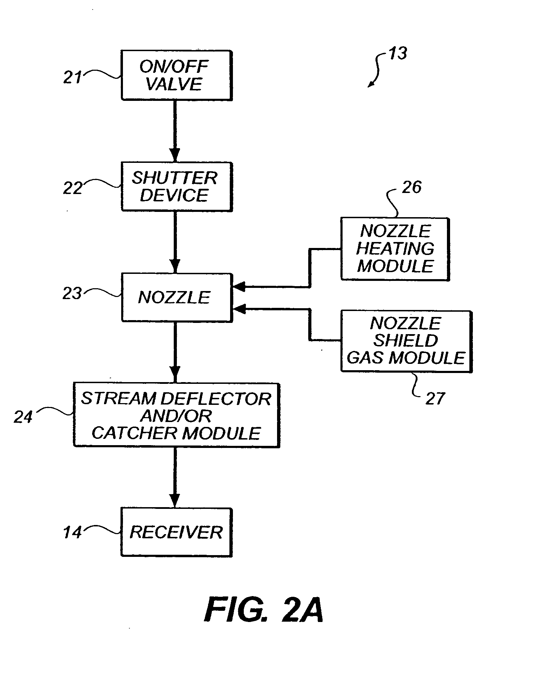

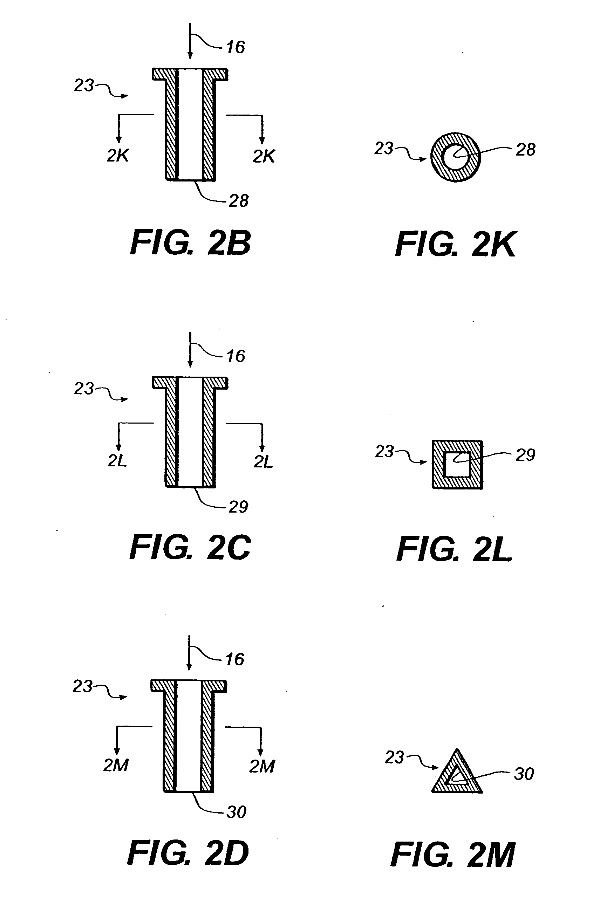

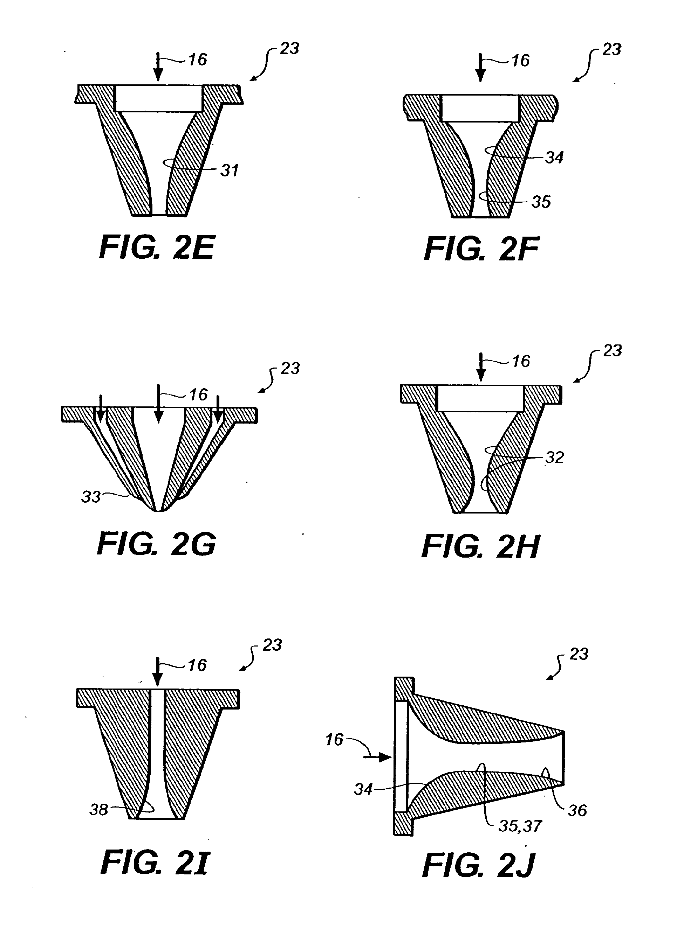

Referring to FIG. 2A, the discharge device 13 is described in more detail. The discharge assembly can include an on/off valve 21 that can be manually or automatically actuated to regulate the flow of the dense liquid formulation. The discharge device 13 includes a shutter device 22 which can also be a programmable valve. The shutter device 22 is capable of being controlled to turn off the flow and/or turn on the flow so that the flow of formulation occupies all or part of the available cross-section of the discharge device 13. Additionally, the shutter device is capable of being partially opened or closed in order to adjust or regulate the flow of formulation. The discharge assembly also includes a nozzle 23. The nozzle 23 can be provided, as necessary, with a nozzle heating module 26 and a nozzle shield gas module 27 to assist in beam collimation. The discharge device 13 also includes a stream deflector and/or catcher module 24 to assist in shaping the spray prior to the spray reaching a receiver 25. Components 22-24, 26, and 27 of discharge device 13 are positioned relative to delivery path 16 such that the formulation continues along delivery path 16.

Alternatively, the shutter device 22 can be positioned after the nozzle heating module 26 and the nozzle shield gas module 27 or between the nozzle heating module 26 and the nozzle shield gas module 27. Additionally, the nozzle shield gas module 27 may not be required for certain applications, as is the case with the stream deflector and catcher module 24. Alternatively, discharge device 13 can include a stream deflector and catcher module 24 and not include the shutter device 22. In this situation, the stream deflector and catcher module 24 can be moveably positioned along delivery path 16 and used to regulate the flow of formulation such that a continuous flow of formulation exits while still allowing for discontinuous deposition.

The nozzle 23 can be capable of translation in x, y, and z directions to permit suitable discontinuous and/or continuous functional material deposition on the receiver 14. Translation of the nozzle can be achieved through manual, mechanical, pneumatic, electrical, electronic or computerized control mechanisms. Receiver 14 and/or media conveyance mechanism 50 can also be capable of translation in x, y, and z directions to permit suitable functional material deposition on the receiver 14. Alternatively, both the receiver 14 and the nozzle 23 can be translatable in x, y, and z directions depending on the particular application.

In addition to translation of the nozzle 23 and/or receiver 14, there are many configurations possible to achieve relative motion between the nozzle 23 and receiver 14, which may be preferred for the practice of this method. For example, the receiver 14 can be flexible and releasably attached to a spinning drum to provide one axis of motion, with the nozzle translating to provide a second axis of motion. Alternatively, the receiver can be a web that is presented in front of the nozzle via rollers. Many such configurations involving translation and/or rotation of mechanical elements can be found in co-pending applications USSN 10/163,326 entitled "METHOD AND APPARATUS FOR PRINTING, CLEANING, AND CALIBRATING" filed June 5, 2002 in the name of Sridhar Sadasivan et al. and USSN 10/051,888, entitled "METHOD AND APPARATUS FOR PRINTING AND COATING", filed January 17, 2002, in the name of Sridhar Sadasivan et al., which are hereby incorporated herein by reference. Though the remainder of this application discusses the practice of a preferred method specifically as it relates to translation mechanisms and a rigid substrate, it is not intended to limit the use of the present invention to applications of layers to rigid substrates.

Referring to FIGS. 2B-2J, the nozzle 23 functions to direct the formulation flow towards the receiver 14. It is also used to attenuate the final velocity with which the functional material impinges on the receiver 14. Accordingly, nozzle geometry can vary depending on a particular application. For example, nozzle geometry can be a constant area having a predetermined shape (cylinder 28, square 29, triangular 30, etc.) or variable area converging 31, variable area diverging 38, or variable area converging-diverging 32, with various forms of each available through altering the angles of convergence and/or divergence. Alternatively, a combination of a constant area with a variable area, for example, a converging-diverging nozzle with a tubular extension, etc., can be used. In addition, the nozzle 23 can have a shape 33 that allows for coaxial, axisymmetric or asymmetric or any combination thereof (shown generally as shape 33). The shape 28, 29, 30, 31, 32, 33 of the nozzle 23 can assist in regulating the flow of the formulation. In a preferred embodiment of the present invention, the nozzle 23 includes a converging section or module 34, a throat section or module 35, and a diverging section or module 36. The throat section or module 35 of the nozzle 23 can have a straight section or module 37.

The discharge device 13 serves to direct the functional material onto the receiver 14. The discharge device 13 or a portion of the discharge device 13 can be stationary or can swivel or raster, as needed, to provide high resolution and high precision deposition of the functional material onto the receiver 14. Alternatively, receiver 14 can move in a predetermined way while discharge device 13 remains stationary. The shutter device 22 can also be positioned after the nozzle 23. As such, the shutter device 22 and the nozzle 23 can be separate devices so as to position the shutter 22 before or after the nozzle 23 with independent controls for maximum deposition flexibility. Alternatively, the shutter device 22 can be integrally formed within the nozzle 23.

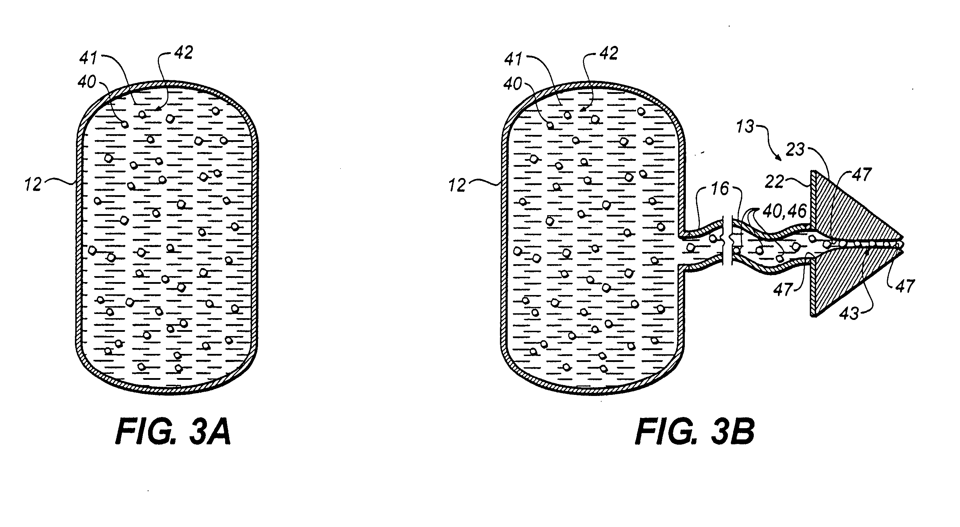

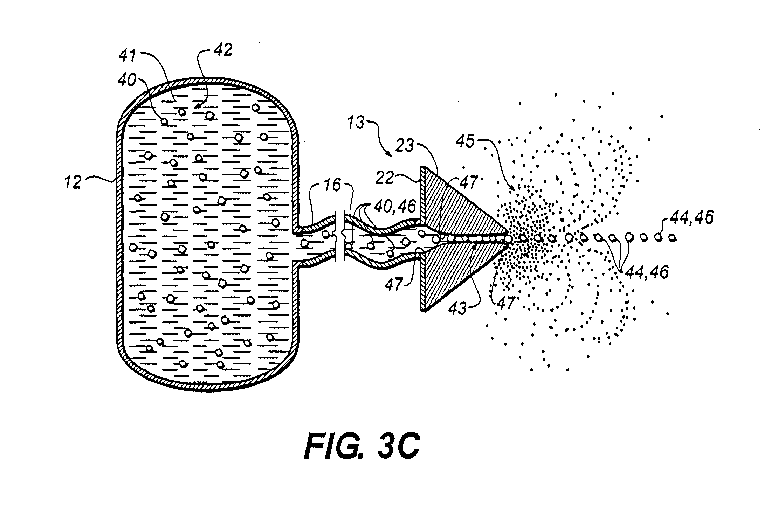

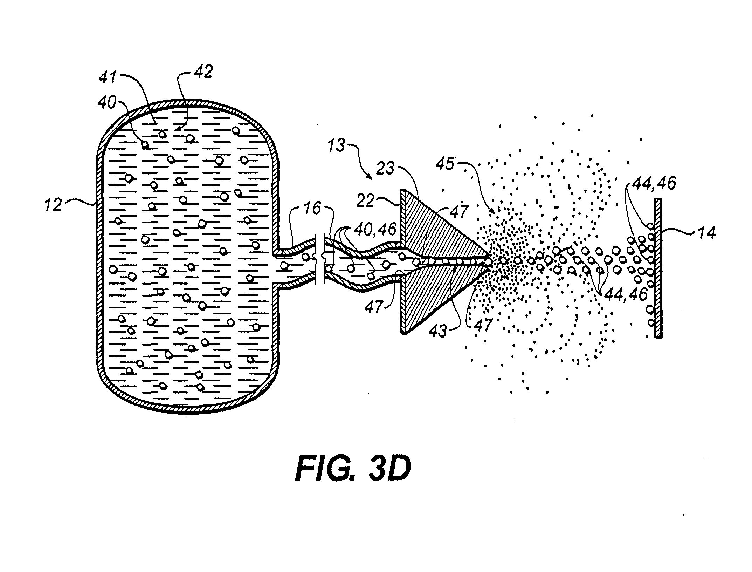

Operation of the delivery system 10 will now be described. FIGS. 3A-3D are diagrams schematically representing the operation of delivery system 10 and should not be considered as limiting the scope of the invention in any manner. A formulation 42 of functional material 40 in a compressed fluid 41 is prepared in the formulation reservoir 12. A functional material 40, any material of interest in solid or liquid phase, can be dispersed (as shown in FIG. 3A) and/or dissolved in a compressed fluid 41 making a mixture or formulation 42. The functional material 40 can have various shapes and sizes depending on the type of the functional material 40 used in the formulation.

The compressed fluid 41, forms a continuous phase and functional material 40 forms a dispersed and/or dissolved single phase. The formulation 42 (the functional material 40 and the compressed fluid 41) is maintained at a suitable temperature and a suitable pressure for the functional material 40 and the compressed fluid 41 used in a particular application. The shutter 22 is actuated to enable the ejection of a controlled quantity of the formulation 42. The nozzle 23 delivers the spray to the substrate in a generally circular or elliptical shape.

The functional material 40 is controllably introduced into the formulation reservoir 12. The compressed fluid 41 is also controllably introduced into the formulation reservoir 12. The contents of the formulation reservoir 12 are suitably mixed using mixing device 70 to ensure intimate contact between the functional material 40 and compressed fluid 41. As the mixing process proceeds, functional material 40 is dissolved or dispersed within the compressed fluid 41. The process of dissolution/dispersion, including the amount of functional material 40 and the rate at which the mixing proceeds, depends upon the functional material 40 itself, the particle size and particle size distribution of the functional material 40 (if the functional material 40 is a solid), the compressed fluid 41 used, the temperature, and the pressure within the formulation reservoir 12. When the mixing process is complete, the mixture or formulation 42 of functional material and compressed fluid is thermodynamically stable/metastable in that the functional material is dissolved or dispersed within the compressed fluid in such a fashion as to be indefinitely contained in the same state as long as the temperature and pressure within the formulation chamber are maintained constant. This state is distinguished from other physical mixtures in that there is no settling, precipitation, and/or agglomeration of functional material particles within the formulation chamber unless the thermodynamic conditions of temperature and pressure within the reservoir are changed. As such, the functional material 40 and compressed fluid 41 mixtures or formulations 42 of the present invention are said to be thermodynamically stable/metastable.

The functional material 40 can be a solid or a liquid. Additionally, the functional material 40 can be an organic molecule, a polymer molecule, a metallo-organic molecule, an organic nanoparticle, a polymer nanoparticle, a metallo-organic nanoparticle, an organic microparticles, a polymer micro-particle, a metallo-organic microparticle, and/or composites of these materials, etc. After suitable mixing with the compressed fluid 41 within the formulation reservoir 12, the functional material 40 is uniformly distributed within a thermodynamically stable/metastable mixture, that can be a solution or a dispersion, with the compressed fluid 41. This thermodynamically stable/metastable mixture or formulation 42 is controllably released from the formulation reservoir 12 through the discharge device 13.

During the discharge process, the functional material 40 is precipitated from the compressed fluid 41 as the temperature and/or pressure conditions change. The precipitated functional material 44 is directed towards a receiver 14 by the discharge device 13 as a focussed and/or collimated beam. The particle size of the functional material 40 deposited on the receiver 14 is typically in the range from 1 nanometer to 1000 nanometers. The particle size distribution may be controlled to be uniform by controlling the rate of change of temperature and/or pressure in the discharge device 13, the location of the receiver 14 relative to the discharge device 13, and the ambient conditions outside of the discharge device 13.

The delivery system 10 is also designed to appropriately change the temperature and pressure of the formulation 42 to permit a controlled precipitation and/or aggregation of the functional material 40. As the pressure is typically stepped down in stages, the formulation 42 fluid flow is self-energized. Subsequent changes to the formulation 42 conditions (a change in pressure, a change in temperature, etc.) result in the precipitation and/or aggregation of the functional material 40 coupled with an evaporation (shown generally at 45) of the compressed fluid 41. The resulting precipitated and/or aggregated functional material 44 deposits on the receiver 14 in a precise and accurate fashion. Evaporation 45 of the compressed fluid 41 can occur in a region located outside of the discharge device 13. Alternatively, evaporation 45 of the compressed gas, supercritical fluid and/or compressed liquid 41 can begin within the discharge device 13 and continue in the region located outside the discharge device 13. Alternatively, evaporation 45 can occur within the discharge device 13.

A spray 43 (stream, etc.) of the functional material 40 and the compressed fluid 41 is formed as the formulation 42 moves through the discharge device 13. The receiver 14 is positioned along the path 16 such that the precipitated and/or aggregated functional material 44 is deposited on the receiver 14. The distance of the receiver 14 from the discharge assembly is chosen such that the compressed fluid 41 evaporates from the compressed fluid state to the gas phase (shown generally at 45) prior to reaching the receiver 14. Hence, there is no need for subsequent receiver-drying processes. However, there may be a need for heating for film-annealing purposes. Further, subsequent to the ejection of the formulation 42 from the nozzle 23 and the precipitation of the functional material, additional spray shaping may be achieved using external devices such as electromagnetic fields, mechanical shields, magnetic lenses, electrostatic lenses etc. Alternatively, the receiver 14 can be electrically or electrostatically charged such that the position of the functional material 40 can be controlled.

It is also desirable to control the velocity with which individual particles 46 of the functional material 40 are ejected from the nozzle 23. As there is a sizable pressure drop from within the delivery system 10 to the operating environment, the pressure differential converts the potential energy of the delivery system 10 into kinetic energy that propels the functional material particles 46 onto the receiver 14. The velocity of these particles 46 can be controlled by suitable nozzle design and control over the rate of change of operating pressure and temperature within the system. Further, subsequent to the ejection of the formulation 42 from the nozzle 23 and the precipitation of the functional material 40, additional velocity regulation of the functional material 40 may be achieved using external devices such as electro-magnetic fields, mechanical shields, magnetic lenses, electrostatic lenses etc. Nozzle design and location relative to the receiver 14 also determine the shape of the spray of functional material 40 deposition. The actual nozzle design will depend upon the particular application addressed.

The nozzle 23 temperature can also be controlled. Nozzle temperature control may be controlled as required by specific applications to ensure that the nozzle opening 47 maintains the desired fluid flow characteristics. Nozzle temperature can be controlled through the nozzle- heating module 26 using a water jacket, electrical heating techniques, etc. With appropriate nozzle design, the exiting stream temperature can be controlled at a desired value by enveloping the exiting stream with a co-current annular stream of a warm or cool, inert gas, as shown in FIG. 2G.

The receiver 14 can be any solid including an organic, an inorganic, a metallo-organic, a metallic, an alloy, a ceramic, a synthetic and/or natural polymeric, a gel, a glass, and a composite material. The receiver 14 can be porous or non-porous. Additionally, the receiver 14 can have more than one layer. The receiver materials will be dictated by the lighting device architecture.

### General lighting device architecture

The present invention can be employed in most OLED and PLED device configurations. These include very simple structures comprising a single anode and cathode to more complex devices, such as passive matrix displays comprised of orthogonal arrays of anodes and cathodes to form pixels, and active-matrix displays where each pixel is controlled independently, for example, with a thin film transistor (TFT).

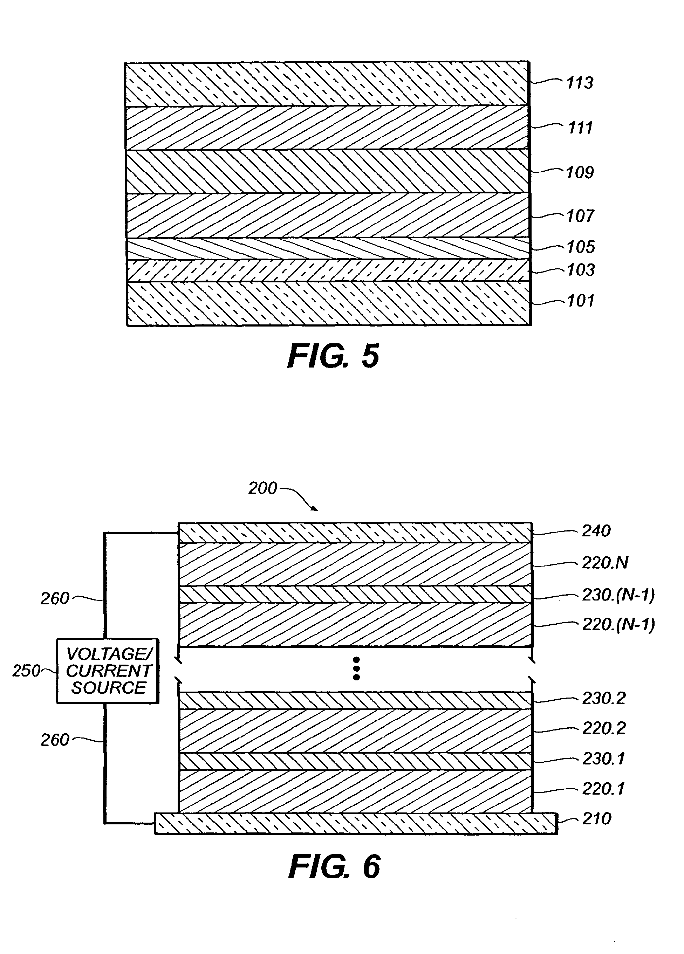

There are numerous configurations of the organic layers wherein the present invention can be successfully practiced. A typical structure is shown in Figure 5 and is comprised of a substrate 101, an anode layer 103, an optional hole-injecting layer 105, a hole-transporting layer 107, a light-emitting layer 109, an electron-transporting layer 111, and a cathode layer 113. These layers are described in detail below. Note that the substrate may alternatively be located adjacent to the cathode, or the substrate may actually constitute the anode or cathode. Also, the total combined thickness of the organic layers (OLED materials and/or PLED materials) is preferably less than 500 nm.

### Substrate

The substrate 101 can either be light transmissive or opaque, depending on the intended direction of light emission. The light transmissive property is desirable for viewing the EL emission through the substrate. Transparent glass or plastic are commonly employed in such cases. For applications where the EL emission is viewed through the top electrode, the transmissive characteristic of the bottom support is immaterial, and therefore can be light transmissive, light absorbing or light reflective. Substrates for use in this case include, but are not limited to, glass, plastic, semiconductor materials, ceramics, and circuit board materials. The substrates may be heated during or after deposition, if needed. Of course, it is necessary to provide in these device configurations a light transparent top electrode 113.

### Anode

The conductive anode layer 103 is formed over the substrate and, when EL emission is viewed through the anode, it should be transparent or substantially transparent to the emission of interest. Common transparent anode materials used in this invention are indium-tin oxide and tin oxide, but other metal oxides can work including, but not limited to, aluminum- or indium-doped zinc oxide, magnesium-indium oxide, and nickel-tungsten oxide. In addition to these oxides, metal nitrides, such as gallium nitride, and metal selenides, such as zinc selenide, and metal sulfides, such as zinc sulfide, can be used in layer 103. For applications where EL emission is viewed through the top electrode, the transmissive characteristics of layer 103 are immaterial and any conductive material can be used, transparent, opaque or reflective. Example conductors for this application include, but are not limited to, gold, iridium, molybdenum, palladium, and platinum. Typical anode materials, transmissive or otherwise, have a work function of 4.1 eV or greater. Desired anode materials are commonly deposited by any suitable means other than deposition from dense phases. Exemplary methods depositing anode materials include, for example, evaporation, sputtering, chemical vapor deposition, or electrochemical means. Anodes can also be patterned using well-known photolithographic processes.

### Hole-Injecting Layer (HIL)

While not always necessary, it is often useful that a hole-injecting layer 105 be provided between anode 103 and hole-transporting layer 107. The hole-injecting material can serve to improve the film formation property of subsequent organic layers and to facilitate injection of holes into the hole-transporting layer. Suitable materials for use in the hole-injecting layer include, but are not limited to, porphyrinic compounds as described in US Patent No. 4,720,432 to VanSlyke, and plasma-deposited fluorocarbon polymers as described in US Patent No. 6,208,075 to Hung et al. Alternative hole-injecting materials reportedly useful in organic EL devices are described in EP 0 891 121 A1 to Inou, et al and EP 1,029,909 A1 to Kawamura, etal. The hole-injecting layer may be deposited using the method of the present invention.

### Hole-Transporting Layer (HTL)

The hole-transporting layer 107 of the organic EL device contains at least one hole-transporting compound, such as an aromatic tertiary amine, where the latter is understood to be a compound containing at least one trivalent nitrogen atom that is bonded only to carbon atoms, at least one of which is a member of an aromatic ring. In one form, the aromatic tertiary amine can be an arylamine, such as a monoarylamine, diarylamine, triarylamine, or a polymeric arylamine. Exemplary monomeric triarylamines are illustrated by Klupfel et al. In US Patent No. 3,180,730. Other suitable triarylamines substituted with one or more vinyl radicals and/or comprising at least one active hydrogen containing group are disclosed by Brantley et al in US Patent Nos. 3,567,450 and 3,658,520.

A more preferred class of aromatic tertiary amines are those which include at least two aromatic tertiary amine moieties as described in US Patent No 4,720,432 to VanSlyke and US Patent No. 5,061,569 to VanSlyke, et al. . Such compounds include those represented by structural formula (C). 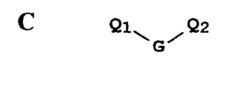 wherein Q₁ and Q₂ are independently selected aromatic tertiary amine moieties and G is a linking group such as an arylene, cycloalkylene, or alkylene group of a carbon to carbon bond. In one embodiment, at least one of Q₁ or Q₂ contains a polycyclic fused ring structure, e.g., a naphthalene. When G is an aryl group, it is conveniently a phenylene, biphenylene, or naphthalene moiety.

A useful class of triarylamines satisfying structural formula (C) and containing two triarylamine moieties is represented by structural formula (D): 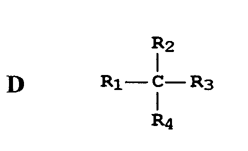 where
R₁ and R₂ each independently represents a hydrogen atom, an aryl group, or an alkyl group or R₁ and R₂ together represent the atoms completing a cycloalkyl group; and
R₃ and R₄ each independently represents an aryl group, which is in turn substituted with a diaryl substituted amino group, as indicated by structural formula (E): 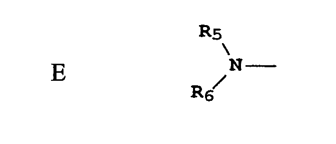 wherein R₅ and R₆ are independently selected aryl groups. In one embodiment, at least one of R₅ or R₆ contains apolycyclic fused ring structure, e.g., a naphthalene.

Another class of aromatic tertiary amines are the tetraaryldiamines. Desirable tetraaryldiamines include two diarylamino groups, such as indicated by formula (E), linked through an arylene group. Useful tetraaryldiamines include those represented by formula (F). 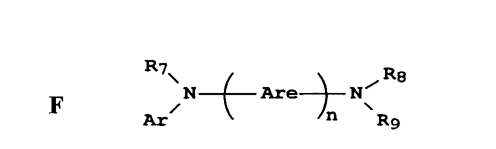 wherein:
each Ar is an independently selected arylene group, such as a phenylene or anthracene moiety,
n is an integer of from 1 to 4, and
Ar, R₇, R₈, and R₉ are independently selected aryl groups.

In a typical embodiment, at least one of Ar, R₇, R₈, and R₉ is a polycyclic fused ring structure, e.g., a naphthalene

The various alkyl, alkylene, aryl, and arylene moieties of the foregoing structural formulae (C), (D), (E), (F), can each in turn be substituted. Typical substituents include alkyl groups, alkoxy groups, aryl groups, aryloxy groups, and halogen such as fluoride, chloride, and bromide. The various alkyl and alkylene moieties typically contain from about 1 to 6 carbon atoms. The cycloalkyl moieties can contain from 3 to about 10 carbon atoms, but typically contain five, six, or seven ring carbon atoms--e.g., cyclopentyl, cyclohexyl, and cycloheptyl ring structures. The aryl and arylene moieties are usually phenyl and phenylene moieties.

The hole-transporting layer can be formed of a single or a mixture of aromatic tertiary amine compounds. Specifically, one may employ a triarylamine, such as a triarylamine satisfying the formula (D), in combination with a tetraaryldiamine, such as indicated by formula (F). When a triarylamine is employed in combination with a tetraaryldiamine, the latter is positioned as a layer interposed between the triarylamine and the electron injecting and transporting layer. Illustrative of useful aromatic tertiary amines are the following:
1,1-Bis(4-di-p-tolylaminophenyl)cyclohexane
1,1-Bis(4-di-p-tolylaminophenyl)-4-phenylcyclohexane
4,4'-Bis(diphenylamino)quadriphenyl
Bis(4-dimethylamino-2-methylphenyl)-phenylmethane
N,N,N-Trip-tolyl)amine
4-(di-p-tolylamino)-4'-[4(di-p-tolylamino)-styryl]stilbene
N,N,N',N'-Tetra-p-tolyl-4-4'-diaminobiphenyl
N,N,N',N'-Tetraphenyl-4,4'-diaminobiphenyl
N-Phenylcarbazole
Poly(N-vinylcarbazole), and
N,N'-di-1-naphthalenyl-N,N'-diphenyl-4, 4'-diaminobiphenyl.
4,4'-Bis[N-(1-naphthyl)-N-phenylamino]biphenyl
4,4"-Bis[N-(1-naphthyl)-N-phenylamino]p-terphenyl
4,4'-Bis[N-(2-naphthyl)-N-phenylamino]biphenyl
4,4'-Bis[N-(3-acenaphthenyl)-N-phenylamino]biphenyl
1,5-Bis[N-(1-naphthyl)-N-phenylamino]naphthalene
4,4'-Bis[N-(9-anthryl)-N-phenylamino]biphenyl
4,4"-Bis[N-(1-anthryl)-N-phenylamino]-p-terphenyl
4,4'-Bis[N-(2-phenanthryl)-N-phenylamino]biphenyl
4,4'-Bis[N-(8-fluoranthenyl)-N-phenylamino]biphenyl
4,4'-Bis[N-(2-pyrenyl)-N-phenylamino]biphenyl
4,4'-Bis[N-(2-naphthacenyl)-N-phenylamino]biphenyl
4,4'-Bis [N-(2-perylenyl)-N-phenylamino]biphenyl
4,4'-Bis[N-( 1 -coronenyl)-N-phenylamino]biphenyl
2,6-Bis(di-p-tolylamino)naphthalene
2,6-Bis[di-(1-naphthyl)amino]naphthalene
2,6-Bis[N-( 1-naphthyl)-N-(2-naphthyl)amino]naphthalene
N,N,N',N'-Tetra(2-naphthyl)-4,4"-diamino-p-terphenyl
4,4'-Bis {N-phenyl-N-[4-( 1-naphthyl)-phenyl]amino} biphenyl
4,4'-Bis[N-phenyl-N-(2-pyrenyl)amino]biphenyl
2,6-Bis[N,N-di(2-naphthyl)amine]fluorene
1,5-Bis[N-( 1-naphthyl)-N-phenylamino]naphthalene

Another class of useful hole-transporting materials includes polycyclic aromatic compounds as described in US Patent No. 6,361,886 to Shi, et al. The hole-transporting layer is deposited using the method of the present invention.

### Light-Emitting Layer (LEL)

As more fully described in US Patent Nos. 4,769,292 to Tang, et al and 5,935,721 to Shi, et al, the light-emitting layer (LEL) 109 of the organic EL element comprises a luminescent or fluorescent material where electroluminescence is produced as a result of electron-hole pair recombination in this region. The light-emitting layer is deposited using the method of the present invention. The light-emitting layer can be comprised of a single material, but more commonly consists of a host material doped with a guest compound or compounds where light emission comes primarily from the dopant and can be of any color. The host materials in the light-emitting layer can be an electron-transporting material, as defined below, a hole-transporting material, as defined above, or another material that supports hole-electron recombination. The dopant is usually chosen from highly fluorescent dyes, but phosphorescent compounds, e.g., transition metal complexes as described in WO 98/55561, WO 00/18851, WO 00/57676, and WO 00/70655 are also useful. Dopants are typically coated as 0.01 to 10 % by weight into the host material.

An important relationship for choosing a dye as a dopant is a comparison of the bandgap potential which is defined as the energy difference between the highest occupied molecular orbital and the lowest unoccupied molecular orbital of the molecule. For efficient energy transfer from the host to the dopant molecule, a necessary condition is that the band gap of the dopant is smaller than that of the host material.

Host and emitting molecules known to be of use include, but are not limited to, those disclosed in US 4,768,292, US 5,141,671, US 5,150,006, US 5,151,629, US 5,405,709, US 5,484,922, US 5,593,788, US 5,645,948, US 5,683,823, US 5,755,999, US 5,928,802, US 5,935,720, US 5,935,721, and US 6,020,078.

Metal complexes of 8-hydroxyquinoline and similar derivatives (Formula G) constitute one class of useful host compounds capable of supporting electroluminescence, and are particularly suitable for light emission of wavelengths longer than 500 nm, e.g., green, yellow, orange, and red. 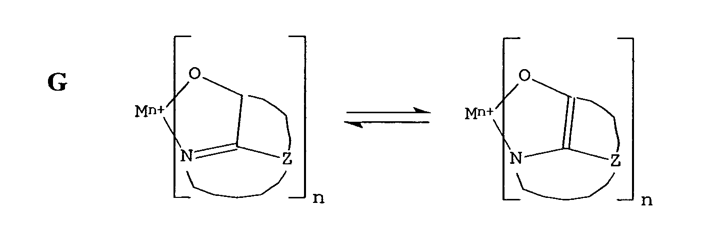 wherein:
M represents a metal;
n is an integer of from 1 to 3; and
Z independently in each occurrence represents the atoms completing a nucleus having at least two fused aromatic rings.

From the foregoing, it is apparent that the metal can be monovalent, divalent, or trivalent metal. The metal can, for example, be an alkali metal, such as lithium, sodium, or potassium; an alkaline earth metal, such as magnesium or calcium; or an earth metal, such as boron or aluminum. Generally any monovalent, divalent, or trivalent metal known to be a useful chelating metal can be employed.

Z completes a heterocyclic nucleus containing at least two fused aromatic rings, at least one of which is an azole or azine ring. Additional rings, including both aliphatic and aromatic rings, can be fused with the two required rings, if required. To avoid adding molecular bulk without improving on function the number of ring atoms is usually maintained at 18 or less.

Illustrative of useful chelated oxinoid compounds are the following:
CO-1: Aluminum trisoxine [alias, tris(8-quinolinolato)aluminum(III)]
CO-2: Magnesium bisoxine [alias, bis(8-quinolinolato)magnesium(II)]
CO-3: Bis[benzo{f}-8-quinolinolato]zinc (II)
CO-4: Bis(2-methyl-8-quinolinolato)aluminum(III)-µ-oxo-bis(2-methyl-8-quinolinolato) aluminum(III)
CO-5: Indium trisoxine [alias, tris(8-quinolinolato)indium]
CO-6: Aluminum tris(5-methyloxine) [alias, tris(5-methyl-8-quinolinolato) aluminum(III)]
CO-7: Lithum oxine [alias, (8-quinolinolato)lithium(I)]

Derivatives of 9,10-di(2-naphthyl)anthracene (Formula H) constitute one class of useful hosts capable of supporting electroluminescence, and are particularly suitable for light emission of wavelengths longer than 400 nm, e.g., blue, green, yellow, orange or red. 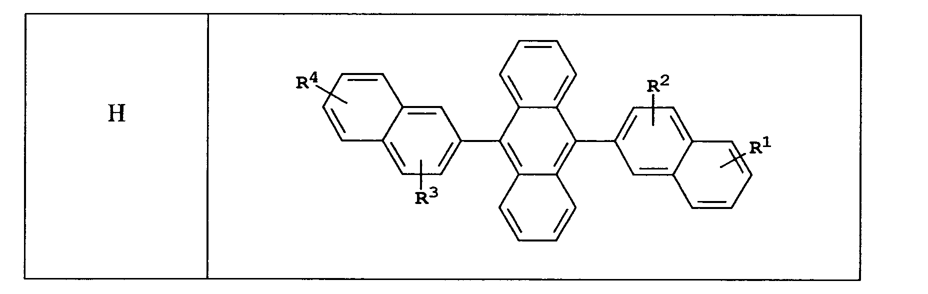 wherein: R¹, R², R³, and R⁴ represent one or more substituents on each ring where each substituent is individually selected from the following groups:
Group 1: hydrogen, or alkyl of from 1 to 24 carbon atoms;
Group 2: aryl or substituted aryl of from 5 to 20 carbon atoms;
Group 3: carbon atoms from 4 to 24 necessary to complete a fused aromatic ring of anthracenyl; pyrenyl, or perylenyl;
Group 4: heteroaryl or substituted heteroaryl of from 5 to 24 carbon atoms as necessary to complete a fused heteroaromatic ring of furyl, thienyl, pyridyl, quinolinyl or other heterocyclic systems;
Group 5: alkoxylamino, alkylamino, or arylamino of from 1 to 24 carbon atoms; and
Group 6: fluorine, chlorine, bromine or cyano.

Benzazole derivatives (Formula I) constitute another class of useful hosts capable of supporting electroluminescence, and are particularly suitable for light emission of wavelengths longer than 400 nm, e.g., blue, green, yellow, orange or red. 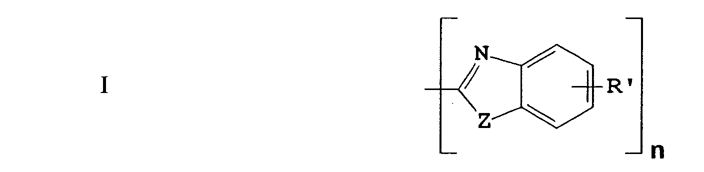 where:
N is an integer of 3 to 8;
Z is O, NR or S; and
R and R' are individually hydrogen; alkyl of from 1 to 24 carbon atoms, for example, propyl, t-butyl, heptyl, and the like; aryl or hetero-atom substituted aryl of from 5 to 20 carbon atoms for example phenyl and naphthyl, furyl, thienyl, pyridyl, quinolinyl and other heterocyclic systems; or halo such as chloro, fluoro; or atoms necessary to complete a fused aromatic ring;
B is a linkage unit consisting of alkyl, aryl, substituted alkyl, or substituted aryl, which conjugately or unconjugately connects the multiple benzazoles together.

An example of a useful benzazole is 2, 2', 2"-(1,3,5-phenylene)tris[1-phenyl-1-H-benzimidazole].

Desirable fluorescent dopants include derivatives of anthracene, tetracene, xanthene, perylene, rubrene, coumarin, rhodamine, quinacridone, dicyanomethylenepyran compounds, thiopyran compounds, polymethine compounds, pyrilium and thiapyrilium compounds, and carbostyryl compounds. Illustrative examples of useful dopants include, but are not limited to, the following:

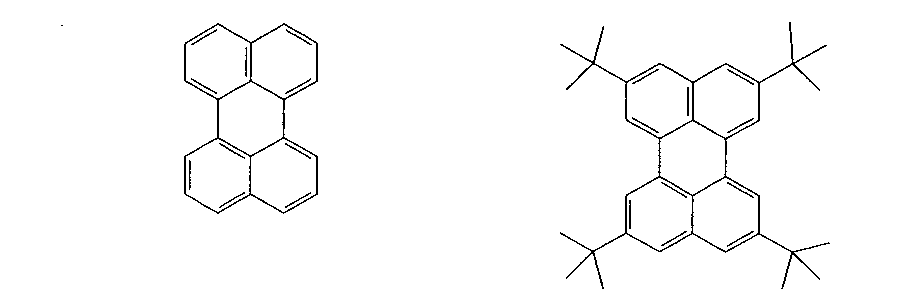

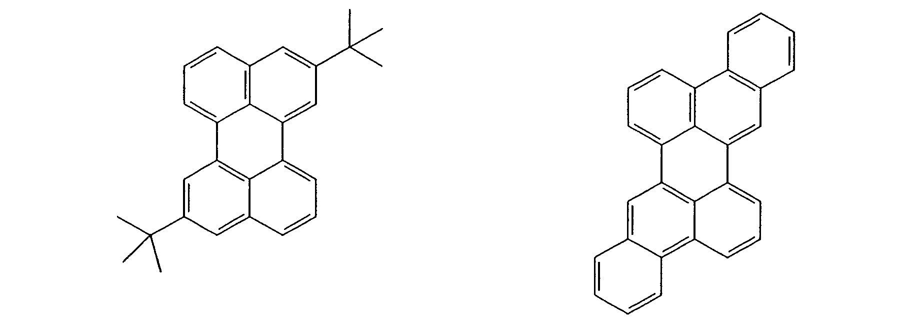

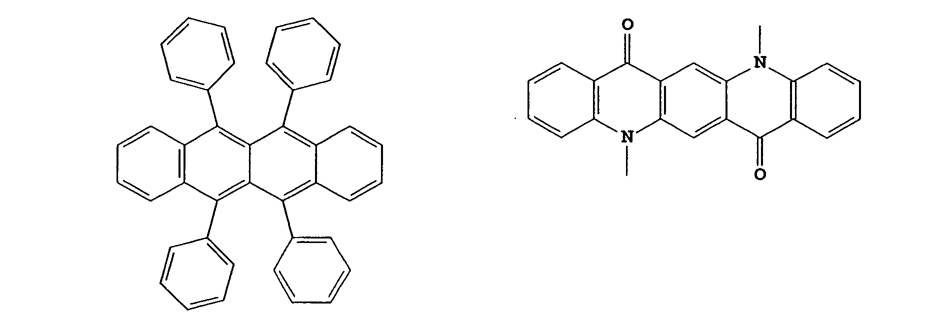

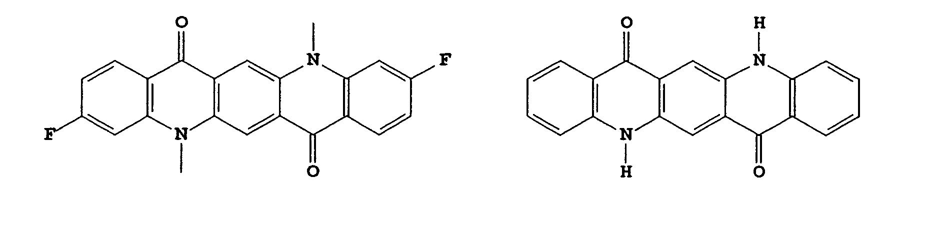

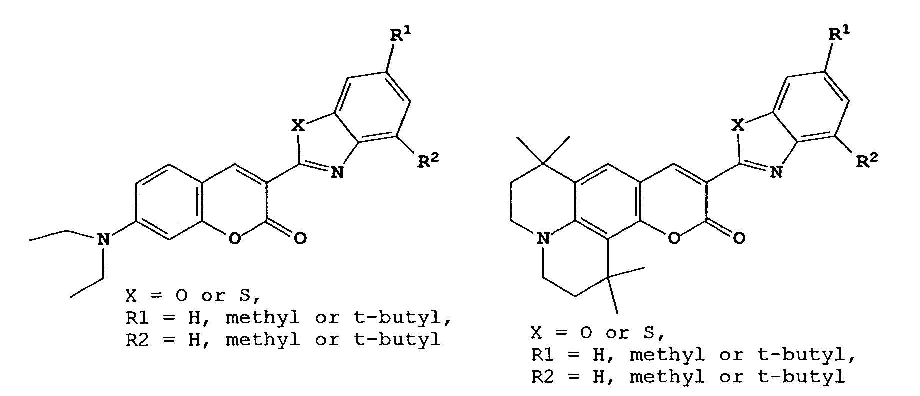

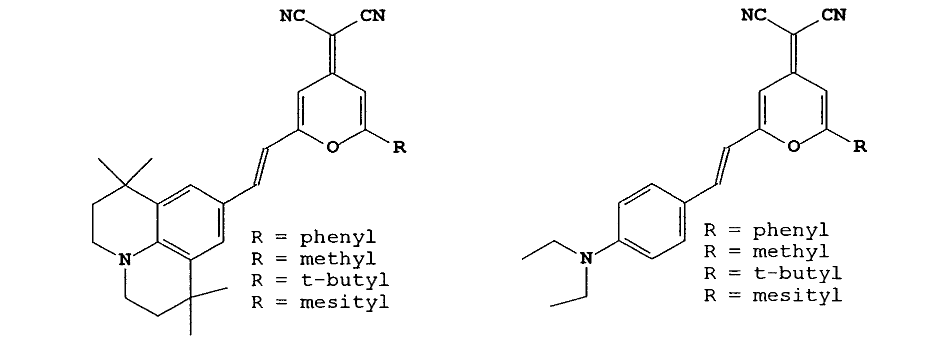

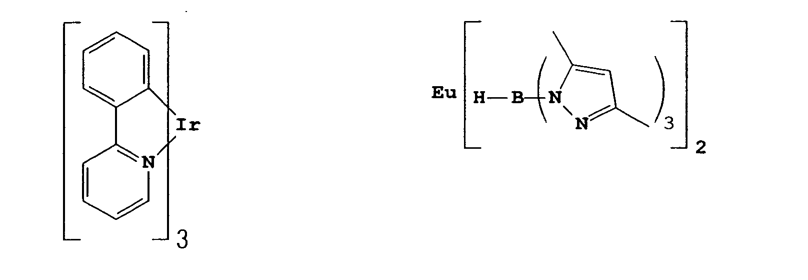

### Electron-Transporting Layer (ETL)

Preferred thin film-forming materials for use in forming the electron-transporting layer **111** of the organic EL devices of this invention are metal chelated oxinoid compounds, including chelates of oxine itself (also commonly referred to as 8-quinolinol or 8-hydroxyquinoline). Such compounds help to inject and transport electrons and exhibit both high levels of performance and are readily fabricated in the form of thin films. Exemplary of contemplated oxinoid compounds are those satisfying structural formula (G), previously described. The electron-transporting layer is preferably deposited using the method of the present invention.

Other electron-transporting materials include various butadiene derivatives as disclosed in US Patent No. 4,356,429 to Tang and various heterocyclic optical brighteners as described in US Patent No. 4,539,507 to VanSlyke. Benzazoles satisfying structural formula (I) are also useful electron transporting materials.

In some instances, layers **109** and **111** can optionally be collapsed into a single layer that serves the function of supporting both light emission and electron transportation.

### Cathode

When light emission is through the anode, the cathode layer **113** used in this invention can be comprised of nearly any conductive material. Desirable materials have good film-forming properties to ensure good contact with the underlying organic layer, promote electron injection at low voltage, and have good stability. Useful cathode materials often contain a low work function metal (< 4.0 eV) or metal alloy. One preferred cathode material is comprised of a Mg:Ag alloy wherein the percentage of silver is in the range of 1 to 20 %, as described in US Patent No. 4,885,211. Another suitable class of cathode materials includes bilayers comprised of a thin layer of a low work function metal or metal salt capped with a thicker layer of conductive metal. One such cathode is comprised of a thin layer of LiF followed by a thicker layer of A1 as described in US 5,677,572. Other useful cathode materials include, but are not limited to, those disclosed in US Patent Nos. 5,059,861 to Littman, et al, US 5,059,862 to VanSlyke, and US 6,140,763 to Hung, et al.

When light emission is viewed through the cathode, the cathode must be transparent or nearly transparent. For such applications, metals must be thin or one must use transparent conductive oxides, or a combination of these materials. Optically transparent cathodes have been described in more detail in US Patent No. 5,776,623 to Hung, et al. Cathode materials can be deposited by evaporation, sputtering, or chemical vapor deposition. When needed, patterning can be achieved through many well known methods including, but not limited to, through-mask deposition, integral shadow masking as described in US Patent No. 5,276,380 to Tang and EP 0 732 868 to Nagayama, et al, laser ablation, and selective chemical vapor deposition.

### Stacked structures

In order to increase the luminance output, a stacked organic electroluminescent device may be fabricated, where a plurality of organic electroluminescent units may be connected using a doped organic material. In this regard, the stacked electroluminescent device comprises of an anode, a cathode, a plurality of electorluminescent units disposed between the anode and the cathode and a doped organic connector disposed between each electroluminescent unit.

FIG. 6 shows a stacked OLED 200 wherein the organic electroluminescent layers may be deposited by the method of the present invention. This stacked OLED has an anode 210 and a cathode 240, at least one of which is transparent. Disposed between the anode and the cathode are N organic EL units 220, where N is greater than 1. These organic EL units, stacked serially to each other and to the anode and the cathode, are designated 220.1 to 220.N where 220.1 is the first EL unit (adjacent to the anode) and 220.N is the N^{th} unit (adjacent to the cathode). When N is greater than 2, there are organic EL units not adjacent to the anode or cathode, and these can be referred to as intermediate organic EL units. Disposed between any two adjacent organic EL units is a doped organic connector 230. There are a total of N-1 doped organic connectors associated with N organic EL units and they are designated 230.1 to 230.(N-1). Organic connector 230.1 is the doped organic connector between organic EL units 220.1 and 220.2, and 230.(N-1) is the doped organic connector disposed between organic EL units 220.(N-1) and 220.N. The stacked OLED 200 is connected to a voltage/current source 250 through electrical conductors 260.

Stacked OLED 200 is operated by applying an electric potential generated by a voltage/current source 250 between a pair of contact electrodes, anode 210 and cathode 240, such that anode 210 is at a more positive potential with respect to the cathode 240. This externally applied electrical potential is distributed among the N organic EL units in proportion to the electrical resistance of each of these units. The electric potential across the stacked OLED causes holes (positively charged carriers) to be injected from anode 210 into the 1^{st} organic EL unit 220.1, and electrons (negatively charged carriers) to be injected from cathode 210 into the Nth organic EL unit 220.N. Simultaneously, electrons and holes are generated in, and separated from, each of the doped organic connectors (230.1 - 230.(N-1)). Electrons thus generated in, for example, doped organic connector 230.(x-1) (1< x ≤N) are injected towards the anode and into the adjacent organic EL unit 220.(x-1). Likewise, holes generated in the doped organic connector 230.(x-1) are injected towards the cathode and into the adjacent organic EL unit 220.x. Subsequently, these electrons and holes recombine in their corresponding organic EL units to produce light, which is observed via the transparent electrode or electrodes of the OLED.

The number of the organic EL units in the stacked OLED is, in principle, equal to or more than 2. Preferably, the number of the organic EL units in the stacked OLED is such that the luminance efficiency in units of cd/A is improved or maximized.

### Device Architecture

### Organic electroluminescent (EL) units

Each organic EL unit 220 in the stacked OLED 200 is capable of supporting hole and electron transport, and electron-hole recombination to produce light. Each organic EL unit 220 can include a single layer or a plurality of layers. Organic EL unit 220 can be formed from small molecule OLED materials or polymeric LED materials, both known in the art, or combinations thereof. There are many organic EL multilayer structures and materials known in the art that can be used as the organic EL unit of this invention. Each organic EL unit in the stacked OLED device can be the same or different from other units. Some organic EL units can be polymeric LED and other units can be small molecule OLEDs. Each organic EL unit can be selected in order to optimize performance or achieve a desired attribute, for example light transmission through the OLED stack, driving voltage, luminance efficiency, light emission color, manufacturability, device stability, and so forth.

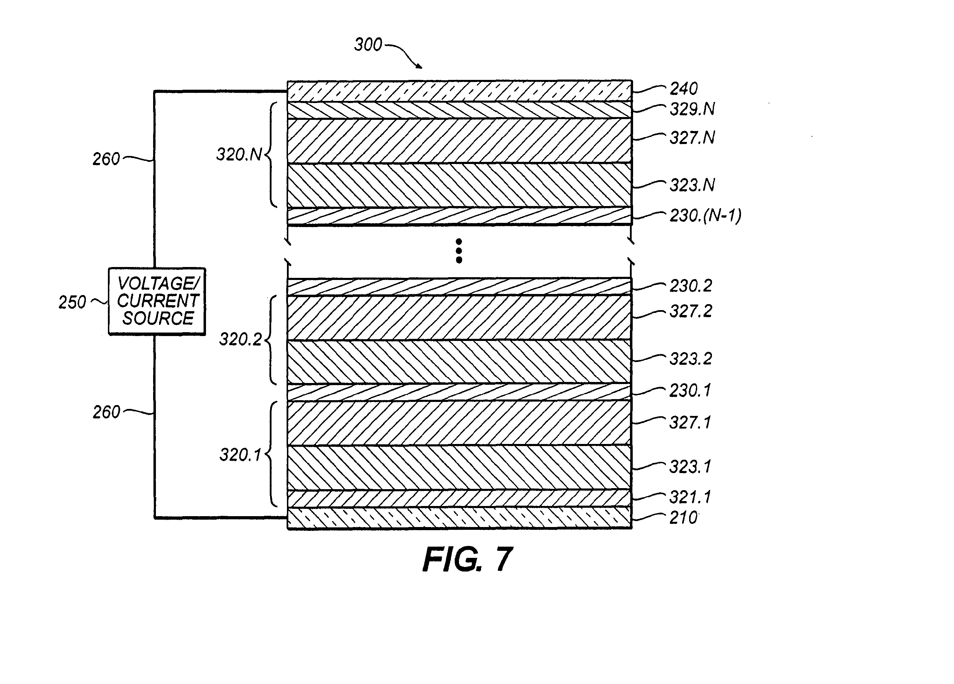

FIG. 7 illustrates another useful embodiment of a stacked OLED 300 wherein the multiple organic electroluminescent layers may be deposited by the method of the present invention. In FIG. 7, there are N organic EL units 320, each comprising HTL 323 and ETL 327. The layer structure of this basic unit is conveniently denoted as HTL/ETL. The doped organic connectors 230 are also provided between organic EL units and function as described above. In device 300 the doped organic connectors facilitate hole injection into the HTL of one organic EL unit and electron injection into ETL of the adjacent organic EL unit. Within each organic EL unit, the transport of the hole and electron carriers is supported by the HTL and ETL, respectively. Recombination of the hole and electron carriers in the vicinity at or near the HTL/ETL interface within each organic EL unit causes light to be produced (electroluminescence). The HTL in each organic EL unit are designated 323.1 to 323.N where, in this embodiment, 323.1 is the HTL in organic EL unit 320.1 adjacent to the anode, and 323.N is the HTL in organic EL unit 320.N adjacent to the cathode. Similarly, the ETL in each organic EL unit are designated 327.1 to 327.N. The HTL in each organic EL unit can be the same or different in terms of materials used, layer thickness, method of deposition, and so forth. The properties of the HTL in the device can be individually optimized to achieve the desired performance or feature, for example, light transmission through the OLED stack, driving voltage, luminance efficiency, light emission color, manufacturability, device stability, and so forth. The same is true for the ETL. Although not necessary, it is preferable that a hole-injecting layer (HIL) 321.1 be provided between anode 210 and the first HTL, 323.N. It is also preferable, but not necessary, that an electron-injecting layer (EIL) 329.N be provided between the cathode and the last ETL, 327.N. Both the HIL and EIL improve charge injection from the electrodes. While not shown in FIG 7, organic EL units can optionally include a HIL between a HTL and a doped organic connector. Similarly, organic EL units can optionally include an EIL between an ETL and a doped organic connector.

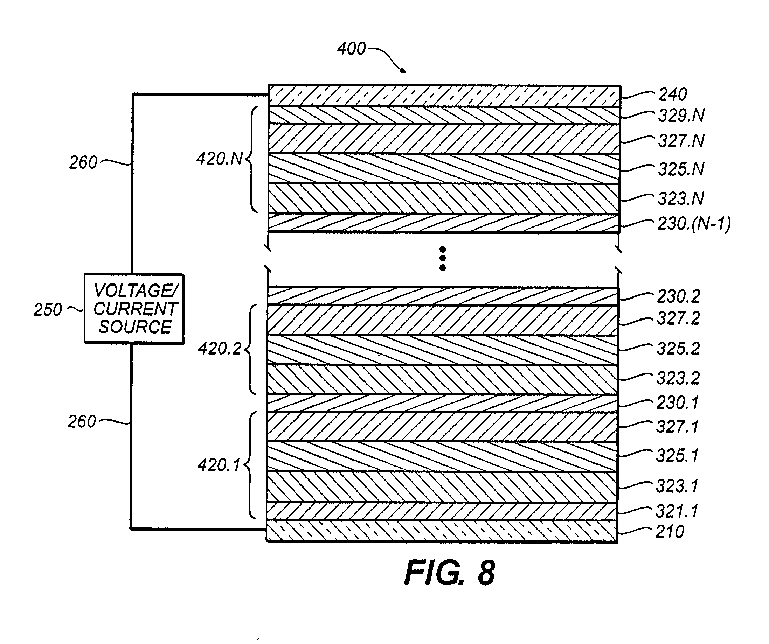

FIG. 8 illustrates another embodiment of a stacked OLED 400, wherein the organic EL unit 420 includes a light-emitting layer (LEL) 325 disposed between a HTL and an ETL. This unit structure is conveniently designated HTL/LEL/ETL. In this embodiment, the recombination of the hole and electron carriers and electroluminescence occurs primarily in the LEL. The LEL in each organic EL unit are designated 325.1 to 325.N where, in this embodiment, 325.1 is the LEL in organic EL unit 420.1 adjacent to the anode, and 325.N is the LEL in organic EL unit 420.N adjacent to the cathode. The properties of the LEL in the device can be individually optimized to achieve the desired performance or feature, for example light transmission through the OLED stack, driving voltage, luminance efficiency, light emission color, manufacturability, device stability, and so forth. The description above regarding the HTL, ETL, HIL, and EIL, apply to FIG 8 as well.

In order to minimize driving voltage for the stacked OLED, it is desirable to make each organic EL unit as thin as possible without compromising the electroluminescence efficiency. It is preferable that each organic EL unit is less than 500 nm thick, and more preferable that it be 2- 200 nm thick. It is also preferable that each layer within the organic EL unit be 200 nm thick or less.

### Doped Organic Connectors

The doped organic connectors provided between adjacent organic EL units are crucial, as this connection is needed to provide for efficient electron and hole injection into the adjacent organic EL units. Each doped organic connector of this invention includes at least one n-type doped organic layer, or at least one p-type doped organic layer, or a combination of layers, thereof. Preferably, the doped organic connector includes both an n-type doped organic layer and a p-type doped organic layer disposed adjacent to one another to form a p-n heterojunction. It is also preferred that the n-type doped organic layer is disposed towards the anode side, and the p-type doped organic layer is disposed towards the cathode side. A non-limiting example of this configuration is shown in FIG. 9, where there are two stacked organic EL units, 320.1 and 320.2. Definitions for ETL, HTL, HIL, and EIL are as defined previously. In stacked OLED 500, n-type doped organic layer 237 is provided between ETL 327.1 and p-type doped organic layer 233. The p-type doped organic layer 233 is provided between n-type doped organic layer 237 and HTL 323.2. The choice of using n-type doped organic layer, or a p-type doped organic layer, or both (the p-n junction) is in part dependent on the organic materials that include the organic EL units. Each connector can be optimized to yield the best performance with a particular set of organic EL units. This includes choice of materials, layer thickness, modes of deposition, and so forth.

An-n-type doped organic layer means that the organic layer has semi-conducting properties after doping, and the electrical current through this layer is substantially carried by the electrons. A p-type doped organic layer means that the organic layer has semi-conducting properties after doping, and the electrical current through this layer is substantially carried by the holes. A p-n heterojunction means an interfacial region (or junction) formed when a p-type layer and an n-type layer are contacted each other.

The n-type doped organic layer in each doped organic connector includes a host organic material and at least one n-type dopant. The host material in the n-typed doped organic layer can include a small molecule material or a polymeric material, or combinations thereof, and it is preferred that it can support electron transport. The p-type doped organic layer in each of the doped organic connector includes a host organic material and at least one p-type dopant. The host material can include a small molecule material or a polymeric material, or combinations thereof, and it is preferred that it can support hole transport. In some instances, the same host material can be used for both n-typed and p-type doped organic layers, provided that it exhibits both hole and electron transport properties set forth above. The n-type doped concentration or the p-type doped concentration is preferably in the range of 0.01 - 10 vol. %. The total thickness of each doped organic connector is typically less than 100 nm, and preferably in the range of about 1 to 100 nm.

The organic electron-transporting materials used in conventional OLED devices represent a useful class of host materials for the n-type doped organic layer. Preferred materials are metal chelated oxinoid compounds, including chelates of oxine itself (also commonly referred to as 8-quinolinol or 8-hydroxyquinoline), such as tris(8-hydroxyquinoline) aluminum. Other materials include various butadiene derivatives as disclosed by Tang (in U.S. Patent No. 4,356,429), various heterocyclic optical brighteners as disclosed by VanSlyke (in U.S. Patent No. 4,539,507), triazines, hydroxyquinoline derivatives, and benzazole derivatives. Silole derivatives, such as 2,5-bis(2',2"-bipridin-6-yl)-1,1-dimethyl-3,4-diphenyl silacyclopentadiene as reported by Murata et al. [Applied Physics Letters, 80, 189 (2002)], are also useful host materials.

The materials used as the n-type dopants in the n-type doped organic layer of the doped organic connectors include metals or metal compounds having a work function less than 4.0 eV. Particularly useful dopants include alkali metals, alkali metal compounds, alkaline earth metals, and alkaline metal compounds. The term "metal compounds" includes organometallic complexes, metal-organic salts, and inorganic salts, oxides and halides. Among the class of metal-containing n-type dopants, Li, Na, K, Rb, Cs, Mg, Ca, Sr, Ba, La, Ce, Sm, Eu, Tb, Dy, or Yb, and their compounds, are particularly useful. The materials used as the n-type dopants in the n-type doped organic layer of the doped organic connectors also include organic reducing agents with strong electron-donating properties. By "strong electron-donating properties" it is meant that the organic dopant should be able to donate at least some electronic charge to the host to form a charge-transfer complex with the host. Non-limiting examples of organic molecules include bis(ethylenedithio)-tetrathiafulvalene (BEDT-TTF), tetrathiafulvalene (TTF), and their derivatives. In the case of polymeric hosts, the dopant can be any of the above or also a material molecularly dispersed or copolymerized with the host as a minor component.

The hole-transporting materials used in conventional OLED devices represent a useful class of host materials for the p-type doped organic layer. Preferred materials include aromatic tertiary amines having at least one trivalent nitrogen atom that is bonded only to carbon atoms, at least one of which is a member of an aromatic ring. In one form, the aromatic tertiary amine can be an arylamine, such as a monoarylamine, diarylamine, triarylamine, or a polymeric arylamine. Other suitable triarylamines substituted with one or more vinyl radicals and/or comprising at least one active hydrogen-containing group are disclosed by Brantley et al. (U.S. Patent Nos 3,567,450 and 3,658,520). A more preferred class of aromatic tertiary amines are those which include at least two aromatic tertiary amine moieties as described by VanSlyke (U.S. Patent Nos 4,720,432 and 5,061,569). Non-limiting examples include as N,N'-di(naphthalene-1-yl)-N,N'-diphenyl-benzidine (NPB) and N,N'-diphenyl-N,N'-bis(3-methylphenyl)-1,1-biphenyl-4,4'-diamine (TPD), and N,N,N' ,N'-tetranaphthyl-benzidine (TNB).

The materials used as the p-type dopants in the p-type doped organic layer of the doped organic connectors are oxidizing agents with strong electron-withdrawing properties. By "strong electron-withdrawing properties" we mean that the organic dopant should be able to accept some electronic charge from the host to form a charge-transfer complex with the host. Some non-limiting examples include organic compounds such as 2,3,5,6-tetrafluoro-7,7,8,8-tetracyanoquinodimethane (F₄-TCNQ) and other derivatives of TCNQ, and inorganic oxidizing agents such as iodine, FeCl3, SbC15, and some other metal chlorides. In the case of polymeric hosts, the dopant can be any of the above or also a material molecularly dispersed or copolymerized with the host as a minor component.

Examples of materials that can be used as host for either the n-type or p-type doped organic layers include, but are not limited to: various anthracene derivatives as described in Formula F below and in U.S. Patent No. 5,972,247 to Shi, et al, certain carbazole derivatives, such as 4,4-bis(9-dicarbazolyl)-biphenyl (CBP); and distyrylarylene derivatives such as 4,4'-bis(2,2'-diphenyl vinyl)-1,1'-biphenyl and as described in U.S. Patent No. 5,121,029 to Hosakawa, et al.

The materials used for fabricating the doped organic connectors of this invention are substantially transparent to emitting light.

### Encapsulation

Most OLED devices are sensitive to moisture and/or oxygen and must therefore be encapsulated in a hermetic enclosure that includes an oxygen and moisture impenetrable substrate and cover member that are sealed in a dry, inert, atmosphere such as nitrogen or argon. A desiccant such as alumina, bauxite, calcium sulfate, clays, silica gel, zeolites, alkaline metal oxides, alkaline earth metal oxides, sulfates, or metal halides and perchlorates may be used to dry the process chamber atmosphere and may be included in the enclosure as described in US Patent No. 6,226,890 to Boroson, et al. The cover member may be directly deposited over the cathode structure of the OLED device or may consist of a separate element that is bonded to the substrate subsequent to deposition of the EL layers. Hermetic bonding of the substrate and cover member may be accomplished by a variety of means, e.g., direct bonding, represented by surface activation methods and electrostatic or anodic bonding and indirect bonding where an intermediate material is introduced between the substrate and cover member as a bonding agent. Suitable intermediate materials include organic bonding agents such as epoxy compounds that may be filled with micro glass beads, particles or rods, and inorganic bonding agents such as low melting temperature glasses and metallic alloys. An inorganic seal material is preferable to minimize oxygen and moisture permeability and may obviate the need to add a desiccant if the seal is performed under the same dry, inert conditions as the EL layer coating deposition process. A coating such as indium tin oxide, nickel or gold on the substrate and cover member may be used to facilitate adhesion of the bonding agent to the substrate. Ribbons, wires, powders, pastes and preforms of organic and inorganic bonding agents may be dispensed on the substrate perimeter as required. The bonding agent may advantageously be deposited in a precisely controlled manner through the use of ink-jet technologies that propel drops of bonding agent onto a substrate to form discrete drops or continuous traces. The sealing process must not generate damaging by-products from, for example, dissociated gases and is constrained by the temperature limitations of the EL coatings unless it is possible to limit these effects to the seal area.

### Polymeric LEDs

The organic light emitting region can also be a polymeric material, a blend of two or more polymeric materials, or a doped polymer or polymer blend. It is known in the art that semiconductive conjugated polymers or copolymers, polymers which possess a delocalised pi-electron system along the polymer backbone, are known to exhibit electroluminescence by the injection of charge carriers from suitable contact layers. Typical dopants are listed previously for small molecules.

Typical polymeric materials include, but are not limited to, substituted and unsubstituted poly(p-phenylenevinylene) (PPV) derivatives, substituted and unsubstituted poly(p-phenylene) (PPP) derivatives, substituted and unsubstituted polyfluorene (PF) derivatives, substituted and unsubstituted poly(p-pyridine), substituted and unsubstituted poly(p-pyridalvinylene) derivatives, and substituted, unsubstituted poly(p-phenylene) ladder and step-ladder polymers, and copolymers thereof as taught by Diaz-Garcia et al in U.S. Patent 5,881,083 and references therein. The substituents include, but are not limited to, alkyls, cycloalkyls, alkenyls, aryls, heteroaryls, alkoxy, aryloxys, amino, nitro, thio, halo, hydroxy, and cyano. Specific examples of the above are provided in US Patent . 6,284,435 and WO0226859, which are incorporated by reference herein. Typical polymers are poly(p-phenylene vinylene), dialkyl-, diaryl-, diamino-, or dialkoxy-substituted PPV, mono alkyl-mono alkoxy-substituted PPV, mono aryl-substituted PPV, 9,9'-dialkyl or diaryl-substituted PF, 9,9'-mono alky-mono aryl substituted PF, 9-mono alky or aryl substituted PF, PPP, dialkyl-, diamino-, diaryl-, or dialkoxy-substituted PPP, mono alkyl-, aryl-, alkoxy-, or amino-substituted PPP.

In certain circumstances, it may be advantageous to use polymer precursors which have a higher solubility in organic solvents. Details of the conditions necessary for the chemical synthesis of the monomer, its polymerization to the precursor, and its thermal conversion to PPV are described in the literature, for example in D.D.C. Bradley, J. Phys. D (Applied Physics) 20, 1389 (1987); and J.D. Stenger Smith, R.W. Lenz and G.Wegner; Polymer 30, 1048 (1989).

The organic region can also be a combination of more than one small molecule and polymeric materials with or without dopants.

Some other features of the above layer are specified below. The polymer film is typically of substantially uniform thickness in the range from 10 nm to 5 micrometers and is substantially free of defects that act as non-radiative recombination centers. The polymer ideally should be stable to oxygen and moisture. It should also have good adhesion to an underlying layer, good resistance to stress-induced cracking, and good resistance to shrinkage, swelling, recrystallization or other morphological changes.

The use of an anode and or cathode protection layer may be necessary. The protection layer is chosen to act as a barrier against the conversion by-products of the precursor polymer as described in WO 98/05187 incorporated by reference herein.

### Electrical Considerations

An electrical potential must be developed across the thickness of the EL coatings in order for them to emit light. The intensity of the emitted light is related to the local voltage potential so the transparent, electrically conductive layers acting as the anode or cathode must be sufficiently conductive, and have an adequate number of connection points to maintain a substantially constant voltage across their active area. A number of electrical edge connection locations in parallel may be required on either or both the anode and cathode to achieve the required voltage uniformity across the panel. It may further be required to create narrow, opaque bus structures on the face of the panels that are barely visible at normal viewing distances. The purpose of this bus is to maintain a reasonably constant voltage over the anode area. The bus may consist of aluminum that is deposited in a grid pattern having narrow traces that cover perhaps 10% of the anode area. The use of this bus structure reduces the requirement on the ITO layer that it have low electrical resistance. This in turn reduces the required ITO thickness and thereby improves the optical transmission efficiency of the anode area not obstructed by the bus structure.

### Extraction Efficiency

Refractive index differences between the EL layers, ITO, substrate and air cause as much as 80% of generated light to reflect off the interfaces and be trapped and attenuated in the structure. Only light that is emitted at sufficiently small angles to the substrate normal will escape as useable light. It is therefore desirable to minimize the number of optical transmission layers having different optical indices or to match the indices of the layers. Additionally, it is advantageous to incorporate light piping and scattering structures that are dispersed according to their function in the appropriate coatings to redirect internally reflected light out through the substrate [Yamasaki, T., et. al., *Appl. Phys. Lett.,* 76, 1243 (2000)]. A complimentary approach is to pattern surface features on one or both sides of the emitting-side substrate that effectively increases the critical escape angle [Schnitzer, I., Yablonovitch, E., *Appl. Phys. Lett.,* 63, 2174 (1993)], [Lupton, J. M., et. al., *Appl. Phys. Lett.* 77, 3340 (2000)].

### Mechanical Protection

A plastic laminate may advantageously be applied over a thin glass substrate to increase its shock resistance and durability and may also be advantageously applied over a thin aluminum or glass cover member for the same reasons. This laminate may be patterned so as to serve as a light diffuser and may advantageously include a featured surface in the form of a hemispherical lens array to again improve the light extraction efficiency [Madigan, C., et. al., *Appl. Phys. Lett.,* 76, 1650 (2000)]. Finally, a frame structure is envisioned that supports, protects and provides rigidity to the light panel and additionally provides a convenient and rugged means of making electrical contact.

The entire contents of the patents and other publications referred to in this specification are incorporated herein by reference.

## Claims

1. A method for forming a layer of polymeric electroluminescent material having a controlled thickness and surface uniformity comprising the steps of:
(a) delivering a polymeric electroluminescent material to a vessel;
(b) delivering a fluid to the vessel;
(c) compressing and heating the fluid and the polymeric electroluminescent material in the vessel to form a thermodynamically stable or metastable mixture;
(d) spraying the thermodynamically stable or metastable mixture at a surface, the fluid vaporizing; and
(e) depositing the polymeric electroluminescent material as a light emitting layer on the surface.

2. A method as recited in claim 1 wherein:
the thermodynamically stable or metastable mixture is a molecular aggregate of the polymeric electroluminescent material and the fluid or a solution of the polymeric electroluminescent material and the fluid.

3. A method as recited in claim 1 wherein:
the fluid in the vessel after the compressing and heating step is supercritical.

4. A method as recited in claim 1 further comprising the step of:
(a) applying a first electrode to the surface prior to the spraying step; and
(b) applying a hole transporting layer to the first electrode prior to the spraying step.

5. A method as recited in claim 4 further comprising the step of:
applying a hole injecting layer to the first electrode prior to the spraying step, the hole injecting layer residing between the first electrode and the hole transporting layer.

6. A method as recited in claim 4 further comprising the step of:
(a) applying an electron-transporting layer to the light emitting layer; and
(b) applying a second electrode on top of the electron-transporting layer to yield a solid state lighting device.

7. A method as recited in claim 6 further comprising the step of:
applying a hole injecting layer to the first electrode prior to the spraying step, the hole injecting layer residing between the first electrode and the hole transporting layer.

8. A method as recited in claim 6 further comprising the step of:
encapsulating the solid state lighting device.

9. A method for forming a layer of polymeric electroluminescent material having a controlled thickness and surface uniformity comprising the steps of:
(a) delivering a polymeric electroluminescent material to a vessel;
(b) delivering a fluid to the vessel;
(c) compressing and heating the fluid and the polymeric electroluminescent material in the vessel to form a thermodynamically stable or metastable mixture;
(d) spraying the thermodynamically stable or metastable mixture at a surface, the fluid vaporizing; and
(e) depositing the polymeric electroluminescent material as a light emitting layer on the surface.

10. A method as recited in claim 9, wherein the polymeric electroluminescent materials are substituted and unsubstituted poly(p-phenylenevinylene) derivatives, substituted and unsubstituted poly(p-phenylene) derivatives, substituted and unsubstituted polyfluorene derivatives, substituted and unsubstituted poly(p-pyridine), substituted and unsubstituted poly(p-pyridalvinylene) derivatives, substituted and unsubstituted poly(p-phenylene) ladder and step-ladder polymers, substituted and unsubstituted poly(arylamines).

11. A method as recited in claim 9, wherein the polymeric electroluminescent materials is a combination of more than one small molecule and polymeric material.
